(19) Europäisches Patentamt
European Patent Office
Office européen des brevets

(11) **EP 1 389 794 B1**

(12) **EUROPÄISCHE PATENTSCHRIFT**

(45) Veröffentlichungstag und Bekanntmachung des Hinweises auf die Patenterteilung:
**03.10.2007 Patentblatt 2007/40**

(51) Int Cl.:
*H01J 37/147* *(2006.01)*     *H01J 37/28* *(2006.01)*
*H01J 37/10* *(2006.01)*

(21) Anmeldenummer: **03018256.2**

(22) Anmeldetag: **11.08.2003**

(54) **Strahlführungssystem, Abbildungsverfahren und Elektronenmikroskopiesystem**

Beam guiding system, imaging method, and system for electron microscopy

Système de guidage de faisceau, procédé d'imagerie et système de microscopie électronique

(84) Benannte Vertragsstaaten:
**CZ DE FR GB IT NL**

(30) Priorität: **13.08.2002 DE 10237141**

(43) Veröffentlichungstag der Anmeldung:
**18.02.2004 Patentblatt 2004/08**

(73) Patentinhaber: **LEO Elektronenmikroskopie GmbH**
**73447 Oberkochen (DE)**

(72) Erfinder:
• **Kienzle, Oliver, Dr.**
**73430 Aalen (DE)**
• **Knippelmeyer, Rainer, Dr.**
**73431 Aalen (DE)**
• **Uhlemann, Stephan, Dr.**
**69115 Heidelberg (DE)**
• **Haider, Max, Dr.**
**69251 Gaiberg (DE)**
• **Müller, Heiko, Dr.**
**69126 Heidelberg (DE)**

(74) Vertreter: **Diehl, Hermann O. Th.**
**Diehl & Partner**
**Augustenstrasse 46**
**80333 München (DE)**

(56) Entgegenhaltungen:
**EP-A- 1 182 684       EP-A- 1 280 184**
**US-A- 4 376 249       US-B1- 6 236 052**
**US-B1- 6 323 499      US-B1- 6 326 629**

• **PATENT ABSTRACTS OF JAPAN Bd. 011, Nr. 400 (E-569), 26. Dezember 1987 (1987-12-26) & JP 62 160648 A (JEOL LTD), 16. Juli 1987 (1987-07-16)**
• **SCHMID PETER ET AL: "Outline of a variable-axis lens with arbitrary shift of the axis in one direction" JOURNAL OF VACUUM SCIENCE AND TECHNOLOGY. B, MICROELECTRONICS AND NANOMETER STRUCTURES PROCESSING, MEASUREMENT AND PHENOMENA, AMERICAN INSTITUTE OF PHYSICS, NEW YORK, NY, US, Bd. 19, Nr. 6, November 2001 (2001-11), Seiten 2555-2565, XP012009084 ISSN: 1071-1023**
• **MOONEN D ET AL: "Design of an Electron Projection System with Slider Lenses and Multiple Beams" PROCEEDINGS OF SPIE, Bd. 4688, 5. Juli 2002 (2002-07-05), XP002328504**

**Beschreibung**

Die Erfindung betrifft Strahlführungssysteme, Abbildungsverfahren und Elektronenmikroskopiesysteme, wie in den Ansprüchen definiert.

Herkömmliche Elektronenmikroskopiesysteme umfassen Elektronenmikroskope vom SEM-Typ ("Scanning Electron Microscope"), vom SEEM-Typ ("Secondary Electron Emission Microscope") oder vom LEEM-Typ ("Low Energy Electron Microscope").

Bei Elektronenmikroskopen vom SEM-Typ wird ein feinfokussierter sondenformender Primärelektronenstrahl über die Objektoberfläche bewegt, und eine integrale Sekundärelektronenintensität wird in Abhängigkeit von dem Ort des feinfokussierten Primärelektronenstrahls auf der Objektebene detektiert, um ein elektronenoptisches Abbild des Objekts zu gewinnen.

Bei Elektronenmikroskopen vom SEEM- bzw. LEEM-Typ wird mit einem Primärelektronenstrahl ein ausgedehntes Feld auf der Objektoberfläche beleuchtet, und es werden aus diesem Feld austretende Sekundärelektronen mittels einer Elektronenoptik auf einen ortsauflösenden Detektor abbildungserhaltend abgebildet, um dort ein elektronenoptisches Abbild des Objekts zu erhalten.

Ein Vorteil des Mikroskops vom SEM-Typ ist die lediglich durch die Qualität der Fokussierung des Primärelektronenstrahls limitierte Auflösung der Abbildung, ein Nachteil desselben ist ein bei hoher Auflösung geringer Durchsatz, da die Objektoberfläche Punkt für Punkt bzw. Pixel für Pixel abgetastet werden muß.

Ein Vorteil des Mikroskops vom LEEM- bzw. SEEM-Typ ist die simultane Gewinnung von Bildinformationen in einem ausgedehnten Bereich, ein Nachteil desselben ist eine Limitierung der Auflösung durch die Qualität der Abbildungsoptik, welche mit zunehmender Ausdehnung des abgebildeten Feldes geringer wird.

Ein nicht vorveröffentlichter Stand der Technik gemäß EP 1 280 184 A2 beschreibt ein Elektronenmikroskopiesystem, bei dem ein auslenkbares ausgedehntes Feld der Objektoberfläche auf einen ortsauflösenden Detektor abgebildet wird.

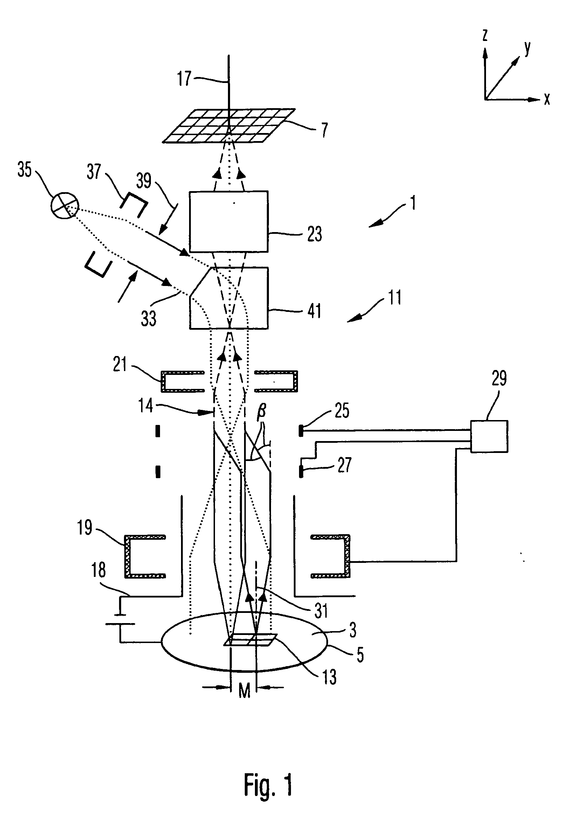

In Figur 1 ist ein solches Elektronenmikroskopiesystem 1 schematisch dargestellt. Es dient zur Abbildung eines in einer Objektebene 3 des Mikroskopiesystems 1 angeordneten Objekts 5 auf einen ortsauflösenden Detektor 7. Hierzu umfaßt das Mikroskopiesystem 1 eine Mikroskopieoptik 11, welche einen Strahlengang für Sekundärelektronen bereitstellt, um einen Bereich 13 der Objektebene 3 auf den Detektor 7 elektronenoptisch abzubilden. Hierbei ist der Bereich 13, der auf den Detektor 7 abgebildet wird, bezüglich einer optischen Achse 17 der Mikroskopieoptik 11 auslenkbar, wobei in Figur 1 eine mögliche Auslenkung des Bereichs 13 von der optischen Achse 17 mit M bezeichnet ist.

Die aus dem Bereich 13 austretenden Sekundärelektronen werden als Sekundärelektronenstrahl 14 von der Mikroskopieoptik 11 zu dem Detektor 7 geführt. Hierzu umfaßt die Mikroskopieoptik mehrere bezüglich der optischen Achse 17 zentriert angeordnete Komponenten, nämlich eine Objektivlinse 19, eine Feldlinse 21 und eine Nachvergrößerungsoptik 23. Zwischen der Objektivlinse 19 und der Feldlinse 21 sind zwei mit Abstand entlang der optischen Achse 17 angeordnete Strahlablenker 25 und 27 vorgesehen. Diese werden von einer Steuerung 29 angesteuert, um für den Sekundärelektronenstrahl 14 jeweils einen einstellbaren Ablenkwinkel einer Größe β bereitzustellen. Die durch die beiden Strahlablenker 25 und 27 bereitgestellte Ablenkwinkel weisen allerdings entgegengesetztes Vorzeichen auf, so daß der Sekundärelektronenstrahl 14 die beiden Strahlablenker geradlinig, allerdings mit einem einstellbaren Versatz M durchsetzt.

Die Sekundärelektronen werden aus dem Objekt 5 durch einen Primärelektronenstrahl 33 ausgelöst, welcher von einer Elektronenquelle 35 erzeugt wird, mit einer Kollimationslinse 37 kollimiert wird, durch eine Aparturblende 39 geformt wird und einem Strahlkombinator 41 zugeführt wird. Der Strahlkombinator 41 überlagert den Strahlengang des Primärelektronenstrahls 33 mit dem Strahlengang des Sekundärelektronenstrahls 14. Auch der Primärelektronenstrahl 33 durchsetzt die Feldlinse 21, die Strahlablenker 25, 27 und die Objektivlinse 19. Auch der Primärelektronenstrahl 33 wird durch die Ablenker 25, 27 abgelenkt, allerdings nicht notwendigerweise um exakt die gleichen Winkel β wie der Sekundärelektronenstrahl 14. Es ist nämlich ausreichend, wenn der Primärelektronenstrahl 33 das Feld 13, welches auf den Detektor 7 abgebildet wird, lediglich einigermaßen homogen bestrahlt. Somit sind an die Abbildungseigenschaften des optischen Systems 11 für den Primärelektronenstrahl 33 geringere Anforderungen geknüpft als an die Abbildungseigenschaften des optischen Systems 11 für den Sekundärelektronenstrahl 14.

Die Objektivlinse 19 stellt für den Sekundärelektronenstrahl 14 ein fokussierendes Feld bereit, dessen optische Achse 31 relativ zu der optischen Achse 17 verlagerbar ist. Die Steuerung 29 steuert die Objektivlinse 19 derart an, daß deren optische Achse 31 mit dem durch die Strahlablenker 25, 27 erzeugten Strahlversatz M zusammenfällt bzw. den auf den Detektor 7 abgebildeten Bereich zentral schneidet.

Ein Beispiel für eine magnetische Rundlinse, deren Achse lateral verlagerbar ist, ist in dem Artikel von Goto et al., "MOL (Moving Objective Lens)", Optic 48 (1977), Seiten 255ff., oder in US 4,376,249 beschrieben.

US 6,326,629 (Krijn) zeigt ein Elektronenstrahl-Lithographiesystem basierend auf dem ähnlichen Konzept der "Variable axis lens", speziell auf Kombination zweier solcher Quadrupollinsen.

Bei einer solchen MOL-Linse ist bei einem begrenzten Bauvolumen der Linse und begrenztem Arbeitsabstand zwischen Objektebene und MOL-Linse eine maximale Auslenkung M eines großen ausgedehnten Bereichs 13 gering. Es wurde deshalb eine Kombination aus einer "Kammlinse" und einer Schlitzblende vorgeschlagen, um ein Rundlinsenfeld nachzubilden, dessen optische Achse über größere Strecken verlagerbar ist.

EP 1 182 684 A2 (de Jager et al.) zeigt eine solche Kammlinse und ein entsprechendes Elektronenstrahl-Lithographiesystem.

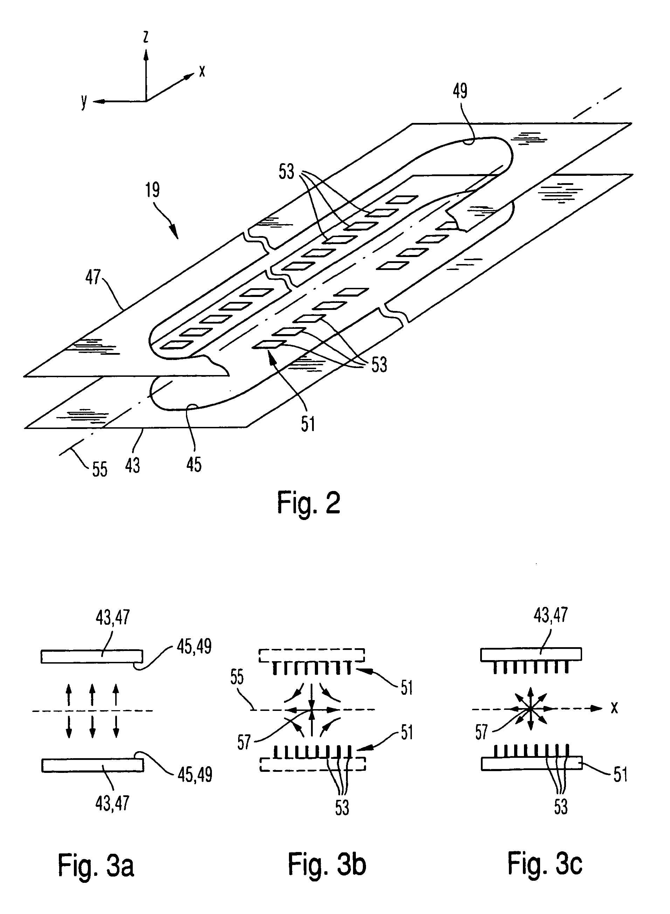

Eine solche zur Nachbildung eines verlagerbaren Rundlinsenfeldes durch Kombination von Kammblende mit Schlitzblenden gebildete Objektivlinse 19 ist in Figur 2 in perspektivischer aufgebrochener Ansicht schematisch dargestellt.

Diese umfaßt drei in z-Richtung übereinander angeordnete Schlitzblenden, nämlich zuunterst eine Blendenelektrode 43 mit einer in x-Richtung langgestreckten Öffnung 45, eine in z-Richtung zuoberst angeordnete Blendenelektrode 47 mit einer ebenfalls in x-Richtung langgestreckten Öffnung 49 sowie einer zwischen den beiden Blendenelektroden 3 und 7 angeordneten Kammblende 51. Die Kammblende 51 umfaßt zwei Reihen aus Fingerelektroden 53, welche beiderseits einer in x-Richtung sich erstreckenden Mittelachse 55 der Kammblende 51 angeordnet sind.

Den beiden Blendenelektroden 43 und 47 sowie den Fingerelektroden 53 werden durch eine in Figur 1 nicht dargestellte Steuerung elektrische Potentiale zugeführt, so daß zwischen den Elektroden 43, 47 und 53 einstellbare elektrische Felder erzeugt werden können. Diese wirken auf einen Strahl elektrisch geladener Teilchen, welcher quer zur xy-Ebene orientiert ist und die Öffnungen der Blenden 47, 51 und 45 durchsetzt. Liegt an den Blendenelektroden 43 oder 47 ein elektrisches Potential an, welches von dem Potential des Strahls geladener Teilchen in der Ebene der Blendenelektroden 43, 47 abweicht, so wirken die Blendenelektroden 43 bzw. 47 auf den Strahl wie eine Zylinderlinse. Ein Verlauf der elektrischen Feldlinien eines Zylinderlinsenfeldes, wie er von einer solchen Blendenelektrode 43, 47 erzeugt wird, ist in Figur 3a schematisch dargestellt.

An die Fingerelektroden 53 der Kammblende 51 kann ein Potentialmuster derart angelegt werden, daß sich in der Öffnung der Blendenelektrode 51 ein elektrisches Quadrupolfeld einstellt. Ein Verlauf von Feldlinien eines solchen Quadrupolfeldes ist in Figur 3b schematisch dargestellt, wobei das Feld eine Symmetrieachse 57 aufweist, die sich in z-Richtung erstreckt und die Längsachse 55 der Kammblende 51 schneidet.

Ein Strahl elektrisch negativ geladener Teilchen, der in dieses Quadrupolfeld eintritt, wird in x-Richtung fokussiert und in y-Richtung defokussiert.

Tritt ein Strahl somit entlang der Symmetrieachse 57 des Quadrupolfeldes in das Objektiv 19 ein, so erfährt er insgesamt die Wirkungen der durch die Blendenelektroden 43 und 47 bereitgestellten Zylinderlinsenfelder gemäß Figur 3a sowie des durch die Kammblende 51 bereitgestellten Quadrupolfelds gemäß Figur 3b. Der Strahl erfährt somit eine Überlagerung der in den Figuren 3a und 3b dargestellten Feldkonfigurationen, und bei geeigneter Abstimmung der Stärken der Zylinderlinsenfelder und des Quadrupolfeldes aufeinander ergibt sich auf den Strahl eine gleiche Wirkung wie die eines zu der Symmetrieachse 57 symmetrischen Rundlinsenfeldes, dessen Feldlinien in Figur 3c schematisch dargestellt sind.

Es ist somit möglich, einen Strahl geladener Teilchen mit dem Objektiv 19 bei geeigneter Beaufschlagung der Elektroden 43, 47 und 53 ähnlich zu fokussieren, wie mit einer Rundlinse, deren optische Achse 57 in x-Richtung verlagerbar ist.

Es hat sich herausgestellt, daß eine mit einer solchen Objektivlinse erzielbare Abbildungsqualität insbesondere bei größer ausgedehnten gleichzeitig abgebildeten Objektfeldern höheren Anforderungen nicht genügt.

Entsprechend ist es eine Aufgabe der vorliegenden Erfindung wie sie in der Ansprüchen definiert ist, teilchenoptische Komponenten bzw. Strahlführungssysteme vorzuschlagen, mit welchen Strahlen geladener Teilchen verlagerbar und formbar sind.

Eine weitere Aufgabe der Erfindung wie sie in den Ansprüchen definiert ist, ist es, ein Verfahren zum Abbilden eines verlagerbaren Objektfelds auf ein fest stehendes Bildfeld vorzuschlagen.

Eine weitere Aufgabe der Erfindung ist es, ein Elektronenmikroskopiesystem mit verbesserten optischen Eigenschaften vorzuschlagen, bei dem ein auf ein Bildfeld abgebildetes ausgedehntes Objektfeld relativ zu dem Bildfeld verlagerbar ist.

Es geht die Erfindung von der Erkenntnis aus, daß die Wirkung der Zylinderlinse gemäß Figur 3a auf den Strahl mit Abstand in Strahlrichtung von der Wirkung der Quadrupollinse gemäß Figur 3b auftritt. Hiermit läßt sich nur angenähert die Wirkung einer Rundlinse erreichen. Aufgrund des Abstandes in Strahlrichtung zwischen der Zylinderlinsenwirkung und der Quadrupollinsenwirkung werden quadrupolartige Wirkungen verbleiben, welche sich zwar hinsichtlich ihrer Brennweiten weitgehend kompensieren können, deren Hauptebenen aber in Strahlrichtung auseinanderfallen. Somit muß eine quadrupolartige Fokussierwirkung verbleiben, welche sich durch die Anordnung aus Quadrupolfeld und Zylinderlinsenfeld nicht wegkompensieren läßt.

Der Erfindung liegt demnach die Erkenntnis zugrunde, daß sich eine Rundlinsenwirkung durch das in Figur 2 gezeigte System niemals ideal erreichen läßt und daß vielmehr Quadrupolwirkungen auf den das System durchsetzenden Strahl verbleiben werden.

Erfindungsgemäß wird das Ziel, der möglichst perfekten Nachbildung einer Rundlinsenwirkung durch das in Figur 2 dargestellte System aufgegeben und ein hierzu entgegengesetzter Weg verfolgt:

Es wird nämlich im Bereich des nichtverlagerbaren Strahlquerschnitts eine Quadrupollinse bereitgestellt, welche eine Quadrupolwirkung, die ein System der in Figur 2 gezeigten Art an einer verlagerbaren Strahlachse bereitstellt, wenigstens teilweise kompensieren kann. Es hat sich herausgestellt, daß beim Aufbau eines Strahlführungssystems nach diesem Prinzip sich insgesamt vergleichsweise bessere Abbildungseigenschaften bei gleichwohl relativ einfachem Aufbau erzielen lassen.

Die Erfindung geht somit aus von einem Strahlführungssystem zum Ablenken eines Strahls geladener Teilchen, welches einen von dem Strahl entlang einer ersten Strahlachse durchsetzten ersten Strahlformer, einen von dem Strahl entlang einer zweiten Strahlachse durchsetzten zweiten Strahlformer und wenigstens einen Strahlablenker umfaßt, der zwischen dem ersten und dem zweiten Strahlformer vorgesehen ist und die erste Strahlachse innerhalb des ersten Strahlformers in einer ersten Richtung verlagert. Der erste Strahlformer stellt hierbei auf den Strahl ein Strahlformungsfeld bereit, welches eine Feldkomponente mit Quadrupolsymmetrie bezüglich der ersten Strahlachse bereitstellt. Hierbei ist die Fokussierwirkung des ersten Strahlformers auf den Strahl in einer zweiten Richtung verschieden von einer Fokussierwirkung des ersten Strahlformers auf den Strahl in einer orthogonal zu der zweiten Richtung orientierten dritten Richtung. Die Fokussierwirkung kann sich hierbei beispielsweise hinsichtlich einer Fokuslänge oder einer Lage der Hauptebene der Fokussierung unterscheiden.

Die Erfindung zeichnet sich unter diesem Aspekt dadurch aus, daß der zweite Strahlformer auf den Strahl ein Strahlformungsfeld bereitstellt, welches ebenfalls eine Feldkomponente mit Quadrupolsymmetrie umfaßt, deren Fokussierwirkungen in der zweiten und der dritten Richtung voneinander verschieden sind. Die Fokussierwirkungen des zweiten Strahlumformers können dann derart eingestellt werden, daß diese die Unterschiede in den Fokussierwirkungen des ersten Strahlformers wenigstens teilweise kompensieren.

Bei dem vorangehend anhand von Figur 1 erläuterten Elektronenmikroskopiesystem muß die Mikroskopieoptik sowohl den Primärelektronenstrahl hin zur Objektebene als auch den Sekundärelektronenstrahl weg von der Objektebene und hin zum Detektor führen, wobei das von dem Primärelektronenstrahl beleuchtete Feld bzw. das durch den Sekundärelektronenstrahl abgebildete Feld in der Objektebene verlagerbar sind. Damit sind an die Mikroskopieoptik hohe Anforderungen geknüpft, wobei die Anforderungen im Hinblick auf eine ortsgetreue Abbildung der Objektebene auf den Detektor an die Wirkung der Mikroskopieoptik auf den Sekundärelektronenstrahl im Vergleich zu der Wirkung auf den Primärelektronenstrahl höher sein können. Es ist allerdings zu berücksichtigen, daß Komponenten der Mikroskopieoptik, die elektrostatische Felder bereitstellen, auf den Primärelektronenstrahl und den Sekundärelektronenstrahl unterschiedliche Wirkungen haben, da diese häufig unterschiedliche kinetische Energien aufweisen. Komponenten der Mikroskopieoptik, die zur Einwirkung auf die Strahlen magnetische Felder bereitstellen, wirken auf die Primär- und Sekundärstrahlen ebenfalls unterschiedlich, da die durch das Magnetfeld erzeugte LorenzKraft auf die Elektronen des Primärelektronenstrahls bzw. Sekundärelektronenstrahls entgegengesetzte Vorzeichen aufgrund der entgegengesetzten Flugrichtung hat.

Damit ist es schwierig, für den Primärelektronenstrahl und den Sekundärelektronenstrahl einen im wesentlichen gemeinsamen Strahlengang bereitzustellen, da durch die herkömmlichen zur Verfügung stehenden teilchenoptischen Komponenten eine beispielsweise auf den Primärelektronenstrahl ausgeübte optische Wirkung ebenfalls eine optische Wirkung auf den Sekundärelektronenstrahl hat. Die optischen Wirkungen auf den Primärelektronenstrahl und den Sekundärelektronenstrahl sind im gemeinsam durchlaufenen Bereich somit streng miteinander gekoppelt und schränken Auslegungen von Mikroskopieoptiken für Primär- und Sekundärelektronenstrahlen stark ein.

Unter einem zweiten Aspekt welcher nicht Teil der vorliegenden Erfindung ist, ist es eine Aufgabe der vorliegenden Erfindung, ein Strahlführungssystem zum Führen zweier Strahlen geladener Teilchen entgegengesetzter Strahlrichtungen vorzuschlagen, welches eine Entkopplung von optischen Wirkungen auf die beiden Strahlen in gewissem Maße ermöglicht.

Hierzu wird ein Strahlführungssystem vor geschlagen, welches wenigstens eine teilchenoptische Linse umfaßt, in welcher zueinander orthogonale elektrische und magnetische Felder bereitgestellt sind, welche jeweils eine Mulitpol Symmetrie mit einer Zähligkeitgröße größer gleich zwei aufweisen. Die Felder haben somit eine Quadrupolsymmetrie, Hexapolsymmetrie oder eine höhere Symmetrie. Eine solche Linse stellt einen Freiheitsgrad bereit, um auf die beiden Strahlen, die die Linse in unterschiedliche Richtungen durchsetzen, gezielte optische Wirkungen auszuüben, welche insbesondere auf beide Strahlen gleiche optische Wirkungen sein können oder derart eingestellt sein können, daß lediglich einer der beiden Strahlen eine optische Wirkung erfährt und der andere Strahl im wesentlichen keine optische Wirkung erfährt.

Um diese Anforderung zu realisieren, ist ein mechanischer Aufbau einer teilchenoptischen Komponente bevorzugt, welcher für die Strahlen eine lichte Weite bzw. einen Bohrungsdurchmesser bzw. einen radialen Abstand von aufeinander zuweisenden Polschuhen bzw. Elektroden vorsieht, welcher größer ist als das dreifache des Durchmessers jeweils der beiden die Linse durchsetzenden Strahlen. Vorzugsweise ist der Durchmesser jeweils größer als ein vierfaches, weiter bevorzugt ein fünffaches, stärker bevorzugt ein sechsfaches und noch stärker bevorzugt ein achtfaches des Strahldurchmessers. Es ist hier dann möglich, daß beide Strahlen eine "ordentliche" Linsenwirkung erfahren, das heißt, daß auch die meisten der über den Querschnitt eines Strahls verteilten Elektronentrajektorien eine Ablenkung erfahren, welche mit der gewünschten Linsenwirkung in Abhängigkeit von einem Abstand der betrachteten Trajektorie von der Symmetrieachse der Linse übereinstimmt. Es gibt dann vergleichsweise wenige Elektronen, welche durch die durch die Linse bereitgestellten Felder derart beeinflußt werden, daß sie durch die Feldwirkung aus dem Strahl "herausgestreut" werden und sich dann nach einer Flugstrecke von mehr als etwa 5 cm oder 10 cm nicht mehr zusammen mit den übrigen Elektronen des Strahls optisch definiert verhalten und insbesondere auch keine ortsabhängige Bildinformation übertragen können.

Wie vorangehend geschildert wurde, können bei einem in Figur 1 erläuterten Elektronmikroskopiesystem an den Strahlengang des Primärelektronenstrahls geringere Anforderungen an die optischen Eigenschaften der Elektronoptik gestellt sein als für den Strahlengang des Sekundärelektronenstrahls. Es hat sich jedoch herausgestellt, daß dann, wenn der Strahlengang des Sekundärelektronenstrahls im Hinblick auf eine große Ausdehnung des abgebildeten Objektfeldes ausgelegt ist, eine einigermaßen homogene Ausleuchtung des Objektfeldes mit dem Primärelektronenstrahl nicht mehr einfach möglich ist. Die Autoren haben einen Grund hierfür unter anderem darin erkannt, daß die kinetischen Energien der Primärelektronen und der Sekundärelektronen bei Durchlaufen der Abbildungsoptik voneinander verschieden sind und somit die teilchenoptischen Komponenten in der Optik auf den Primärelektronenstrahl und den Sekundärelektronenstrahl unterschiedliche Wirkungen haben. Insbesondere ist der Primärelektronenstrahl zur Ausleuchtung eines weiter ausgedehnten Objektfeldes ebenfalls mit einem größeren Durchmesser durch die Optik zu "fädeln". Dieser größere Durchmesser des Primärelektronenstrahls innerhalb der Abbildungsoptik führt zu derartigen Strahlführungsfehlern, daß der Primärelektronenstrahl nicht mehr innerhalb der Optik geführt werden kann.

Hier liegt der Gedanke zugrunde, durch einen großen Teil der Abbildungsoptik den Primärelektronenstrahl mit vergleichsweise kleinem Durchmesser "hindurchzufädeln" und den Primärelektronenstrahl vergleichsweise kurz vor der Objektebene eine "Strahlaufweitung" zu unterziehen.

Hierbei muß die Aufweitung des Primärelektronenstrahls durch eine teilchenoptische Komponente erfolgen, welche auf den Sekundärelektronenstrahl, der diese Komponente in umgekehrte Richtung durchlaufen muß, nicht eine entsprechende dessen Querschnitt reduzierende Wirkung hat, welche die Abbildungseigenschaften für den Sekundärelektronenstrahl stört.

Es wird hierzu eine teilchenoptische Komponente vorgeschlagen, welche ausnutzt, daß der Primärelektronenstrahl und der Sekundärelektronenstrahl diese Komponente in entgegengesetzte Richtung durchsetzen. Diese teilchenoptische Komponente stellt einen Feldbereich bereit, in dem ein magnetisches Feld und ein elektrisches Feld orthogonal zueinander überlagert sind, wobei das elektrische und das magnetische Feld eine Multipolsymmetrie, allerdings keine Dipolsymmetrie, aufweisen. Die Multipole können somit Quadrupol, Hexapol, Octopol usw. umfassen. Hierbei ist es möglich, daß die Feldstärken des magnetischen und elektrischen Feldes derart aufeinander abgestimmt werden, daß die teilchenoptische Komponente auf den Sekundärelektronenstrahl im wesentlichen keine Wirkung hat, dessen geladene Teilchen also im wesentlichen nicht abgelenkt werden. Mit einer solchen teilchenoptischen Komponente ist es also möglich, gezielt den Primärelektronenstrahl zu beeinflussen und insbesondere kurz vor der Objektebene aufzuweiten, ohne dabei die Abbildungseigenschaften des optischen Systems für den Sekundärelektronenstrahl wesentlich zu beeinflussen.

Es wird auch vorgeschlagen, den Primärelektronenstrahl vergleichsweise kurz vor der Objektebene astigmatisch zu verformen und zwar derart, daß er in einer ersten Ebene fokussiert und in einer hierzu orthogonalen zweiten Ebene defokussiert ist, und daß die Fokussierung in der ersten Ebene so stark ist, daß vor der Objektebene ein astigmatischer cross-over, insbesondere ein Strichfokus, entsteht.

Die anhand der Figuren 2 und 3 erläuterte Kammlinse weist eine Vielzahl von Fingerelektroden bzw. Feldquellelementen auf, deren Quellstärken bzw. elektrischen Potentiale zur Erzeugung der gewünschten verlagerbaren Felder einzeln eingestellt werden müssen. Ein herkömmlicher Vorschlag zur Ausgestaltung einer entsprechenden Treiberanordnung sieht vor, daß einem jedem Feldquellelement ein eigener Treiber zugeordnet ist. Dies führt bei einer großen Zahl von Feldquellelementen zu einem beträchtlichen elektronischen Aufwand.

Ausführungsformen der Erfindung sowie nicht zur Erfindung gehörende Beispiele werden nachfolgend anhand von Zeichnungen näher erläutert. Hierbei zeigt

Figur 1      den Aufbau eines herkömmlichen, nicht vorveröffentlichten Elektronenmikroskops,

Figur 2      eine perspektivische aufgebrochene Darstellung eines Objektivs in dem in Figur 1 gezeigten Elektronmikroskop,

Figur 3      Feldverläufe zur Erläuterung des Objektivs gemäß Figur 2,

Figur 4      eine perspektivische schematische Darstellung eines Elektronenmikroskopiesystems gemäß einer Ausführungsform der Erfindung,

Figur 5     einen Querschnitt durch ein Objektiv des Elektronenmikroskopiesystems der Figur 4,

Figur 6     eine perspektivische aufgeschnittene Darstellung eines in dem Mikroskopiesystem gemäß Figur 4 eingesetzten Strahlablenkers,

Figur 7     eine Draufsicht auf einen Teil des Strahlablenkers gemäß Figur 6,

Figur 8     Strahlverläufe durch das in Figur 5 dargestellte Objektiv,

Figur 9     Strahlverläufe eines Abbildungsstrahlengangs durch das in Figur 3 gezeigte Elektronenmikroskopiesystems,

Figur 10    eine Darstellung zur Erläuterung einer Komponente in einem Beleuchtungsstrahlengang des in Figur 3 gezeigten Elektronenmikroskopiesystems,

Figur 11    Strahlengänge in dem Beleuchtungsstrahlengang des Mikroskopiesystems der Figur 3,

Figur 12    eine perspektivische Darstellung einer in dem Mikroskopiesystem gemäß Figur 4 eingesetzten Quadrupollinse,

Figur 13    Darstellungen von Blenden, die in dem Mikroskopieystem gemäß Figur 4 einsetzbar sind,

Figur 14    eine Darstellung einer elektrischen Beschaltung einer Kammlinse,

Figur 15    eine Variante einer in dem Mikroskopiesystem gemäß Figur 4 einsetzbaren elektrostatischen Linse,

Figur 16    Strahlverläufe durch ein Strahlführungssystem welches nicht Teil der Erfindung ist,

Figur 17    weitere Strahlverläufe durch das in Figur 16 erläuterte Strahlführungssystem,

Figur 18    Strahlverläufe durch ein Strahlführungssystem gemäß einer Variante zu Figur 16,

Figur 19    weitere Strahlverläufe durch das in Figur 18 erläuterte Strahlführungssystem und

Figur 20    eine schematische Darstellung eines Lithographiesystems gemäß einer Ausführungsform der Erfindung in perspektivischer Darstellung.

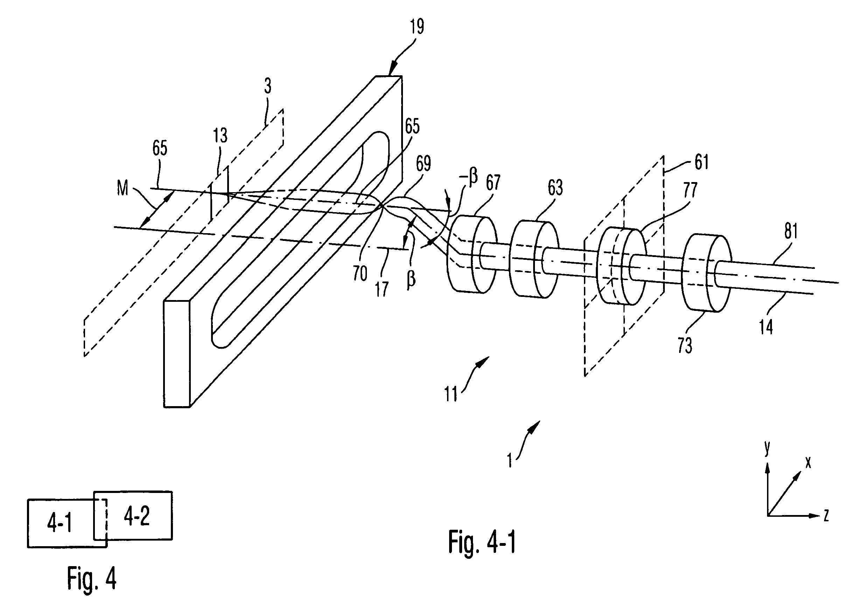

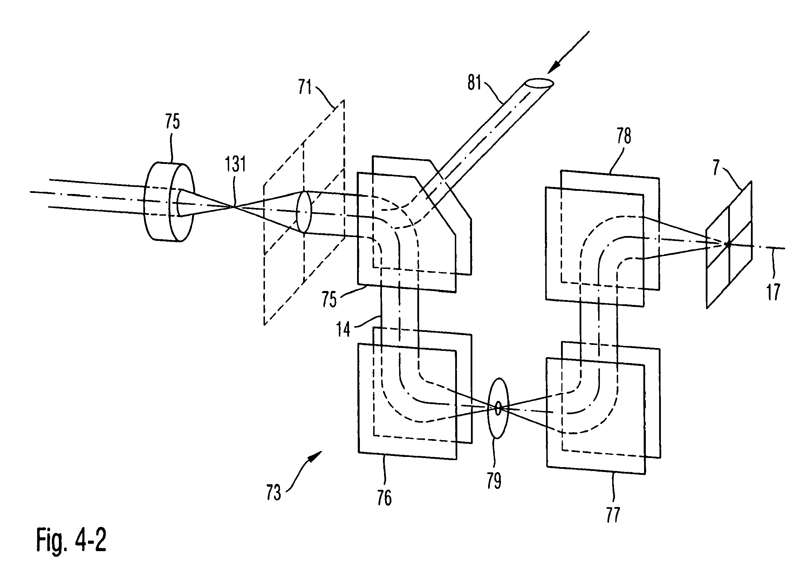

Ein in Figur 4 perspektivisch und schematisch dargestelltes Elektronenmikroskopiesystem 1 gemäß einer Ausführungsform der Erfindung dient zur Abbildung einer Objektebene 3 auf einen ortsauflösenden Detektor 7. Hierbei wird zu einem Zeitpunkt ein Objektfeld 13 der Objektebene 3 auf den Detektor 7 abgebildet. Das abgebildete Objektfeld 13 ist bezüglich einer optischen Hauptachse 17 des Mikroskopiesystems 1 um einen einstellbaren Betrag M auslenkbar. Von dem Objektfeld 13 ausgehende Sekundärelektronen werden zu einem Sekundärelektronenstrahl 14 geformt und durch eine Mikroskopieoptik 11 gefädelt und auf den Detektor 7 übertragen.

Die Mikroskopieoptik 11 umfasst zur Abbildung der Objektebene 3 in eine Zwischenbildebene 61 zunächst einen ersten Strahlformer 19, der im weiteren als Objektiv bezeichnet ist, und einen in Richtung des Sekundärelektronenstrahls 14 mit Abstand von dem Objektiv 19 angeordneten zweiten Strahlformer 63, welche nachfolgend noch im Detail erläutert werden.

Den Strahlformer 63 durchsetzt der Sekundärelektronenstrahl 14 mit fester Position seines Strahlquerschnitts auf der optischen Achse 17.

Das Objektiv 19 hingegen durchsetzt der Sekundärelektronenstrahl 14 entlang einer zu der optischen Hauptachse 17 parallelen Strahlachse 65, welche bezüglich der Hauptachse 17 um den Betrag M ausgelenkt ist. Zur Erzeugung dieser Auslenkung sind zwischen dem Objektiv 19 und dem zweiten Strahlformer 63 zwei Strahlablenker angeordnet, von denen lediglich der näher an dem zweiten Strahlformer 63 angeordnete Strahlablenker 67 in Figur 4 dargestellt ist und der näher an dem Objektiv 19 angeordnete Strahlablenker in Figur 4 der Übersichtlichkeit halber nicht eingetragen ist. Dieser zweite in Figur 4 nicht dargestellte Strahlablenker erzeugt auf den Sekundärelektronenstrahl 14 eine Strahlablenkung um einen Winkel -β an einem Ort des Strahls, welcher in Figur 4 mit dem Bezugszeichen 69 versehen ist. Der Strahlablenker 67 erzeugt auf den Sekundärelektronenstrahl 14 einen Ablenkwinkel β, welcher so bemessen ist, daß der Sekundärelektronenstrahl durch die beiden Ablenker 67, 69 um den Betrag M parallel versetzt wird.

Zwischen dem Objektiv 19 und dem Ablenker 69 ist noch ein cross-over 70 im Sekundärelektronenstrahl vorgesehen.

Die Elektronenmikroskopieoptik 11 bildet die Zwischenbildebene 61 mit dem Sekundärelektronenstrahl 14 in eine weitere Zwischenbildebene 71 ab, wozu zwischen den Zwischenbildebenen 61 und 71 ein Transferlinsenduplett aus zwei zu der Hauptachse 17 zentrierten Rundlinsen 73 und 75 vorgesehen ist. In der Nähe der Zwischenbildebene 61 ist ferner eine zusätzliche ebenfalls zur Hauptachse 71 zentrierte Rundlinse 77 angeordnet.

Zwischen der Zwischenbildebene 71 und dem Detektor 7 ist ein abbildungserhaltender Energiefilter 73 angeordnet, welcher aus dem Sekundärelektronenstrahl 14 Elektronen mit einer einstellbaren vorbestimmten kinetischen Energie zum Detektor 7 unter Erhalt der in dem Strahl enthaltenen Ortsinformation passieren läßt, so daß auf dem Detektor 7 ein Bild der Zwischenbildebene 71 und damit des Objektfelds 13 entsteht.

Ein solcher abbildungserhaltender Energiefilter 73 ist unter anderem aus EP 0 218 920 A2 bekannt und umfaßt vier Sektormagnete 75, 76, 77 und 78, welche der Sekundärelektronenstrahl 14 der Reihe nach durchsetzt. Ein jeder der Sektormagnete 75 bis 78 lenkt den Strahl jeweils um einen Winkel von etwa 90 ° ab und wirkt als Linse derart, daß in einer Ebene zwischen den Sektormagneten 76 und 77 ein Strahl-cross-over entsteht. In dieser Ebene ist ebenfalls eine Aparturblende 79 angeordnet, welche die Energieselektion durchführt. Nur Elektronen mit einer kinetischen Energie innerhalb eines vorbestimmten Energiebereichs können die Aparturblende 79 passieren.

Ein von einer in Figur 4 nicht dargestellten Elektronenquelle erzeugter und kollimierter Primärelektronenstrahl 81 verläuft unter einem Winkel von etwa 135 ° zu dem Sekundärelektronenstrahl 14 auf den Sektormagneten 75 zu und wird von diesem um etwa 45 ° derart abgelenkt, daß der Primärelektronenstrahl 81 nach der Ablenkung in dem Sektormagneten 75 mit dem Strahlengang des Sekundärelektronenstrahls 14 überlagert ist und sich zentriert zu der Hauptachse 17 in Richtung zu der Objektebene 3 hin bewegt. Somit wirkt der Sektormagnet 75 des Energiefilters 73 als Strahlweiche, um Strahlengänge des Primärelektronenstrahls 81 und des Sekundärelektronenstrahls 14 in Überlagerung zu bringen bzw. voneinander zu separieren.

Zwischen der Strahlweiche bzw. dem Sektormagneten 75 und dem Objektfeld 13 stellt die Mikroskopieoptik 11 für den Primärelektronenstrahl 81 und den Sekundärelektronenstrahl 14 einen gemeinsamen Strahlengang bereit, das heißt Querschnitte des Primärelektronenstrahls 81 und des Sekundärelektronenstrahls 14 überlappen wenigstens teilweise oder sind jedenfalls nicht weit voneinander lateral versetzt, obwohl die Elektronen des Primärelektronenstrahls 81 und des Sekundärelektronenstrahls 14 voneinander verschiedene kinetische Energien aufweisen können. So beträgt die kinetische Energie der Elektronen des Primärelektronenstrahls 81 etwa 22 keV und die des Sekundärelektronenstrahls 14 etwa 20 keV.

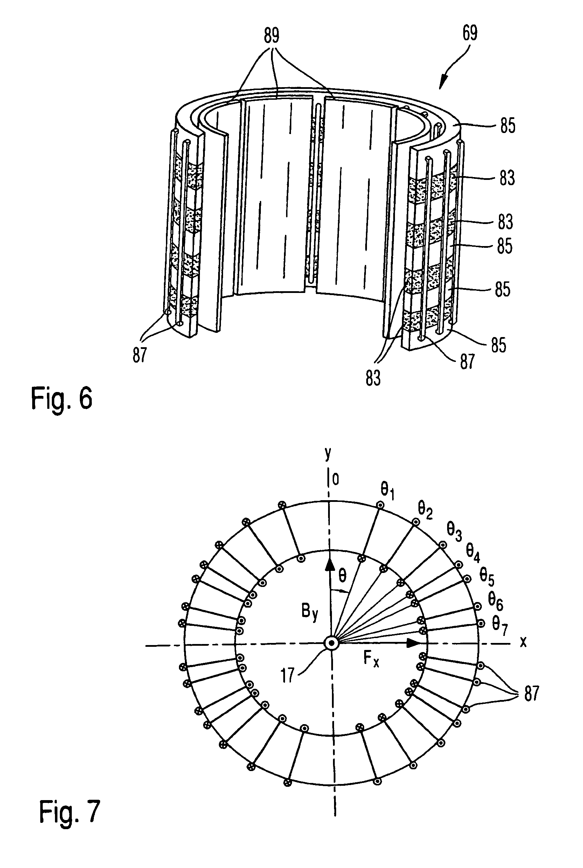

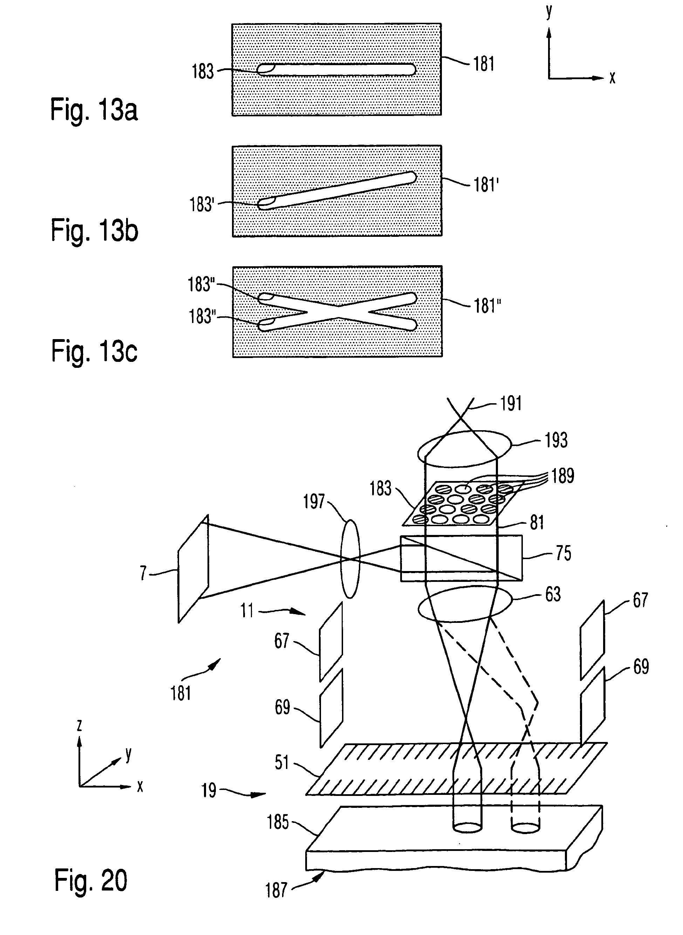

Die Strahlablenker 67 und 69 stellen sowohl für den Primärelektronenstrahl 81 als auch für den Sekundärelektronenstrahl 14 gleiche Ablenkwinkel $\beta$ bzw. $-\beta$ bereit. Hierzu hat der Ablenker 67 einen Aufbau, wie er in den Figuren 6 und 7 für den Ablenker 69 erläutert ist, und der Ablenker 69 hat einen Aufbau, wie er nachfolgend im Zusammenhang mit Figur 12 erläutert ist.

Der Ablenker 67 umfaßt mehrere entlang der Hauptachse 17 konzentrisch angeordnete Ringe 83 aus einem Ferritmaterial mit hoher magnetischer Permeabilität, und mehrere Ringe 85 aus einem Keramikmaterial mit niedriger magnetischer Permeabilität, welche zwischen den Ferritringen 83 sowie an den Enden des somit gebildeten Stapels aus Ringen 83, 85 angeordnet sind. Die an den Enden des Stapels angeordneten Keramikringe 85 werden von einer Mehrzahl von Stromleiterwindungen 87 durchsetzt, welche die Ferritringe 83 umgreifen. Eine Verteilung der Stromleiterwindungen 87 in Umfangsrichtung um die Hauptachse 17 ist aus Figur 7 ersichtlich. Die hierin auftretenden Winkel $\Theta_1$ bis $\Theta_7$ haben folgende Werte: $\Theta_1 = 21{,}6°$, $\Theta_2 = 41{,}6°$, $\Theta_3 = 47{,}6°$, $\Theta_4 = 62{,}4°$, $= 68{,}4°$, $\Theta_6 = 78{,}5°$ und $\Theta_7 = 84{,}5°$. Diese Winkel sind derart gewählt, daß das durch die Stromleiterwindungen 47 erzeugte Magnetfeld ein im wesentlichen homogenes in y-Richtung orientiertes Magnetfeld ist.

Radial innerhalb der Ringe 83, 85 sind acht in Umfangsrichtung gleichmäßig verteilte Elektroden 89 angeordnet, an welche Spannungen derart angelegt werden können, daß in einem Bereich um die Hauptachse 17 ein im wesentlich homogenes und in x-Richtung orientiertes elektrisches Feld bereitgestellt werden kann.

Die Ablenkwinkel $\beta$ bzw. $-\beta$ für die Elektronen des Primärelektronenstrahls und des Sekundärelektronenstrahls sind dann gleich wenn die elektrische Feldstärke und die magnetische Feldstärke in etwa die folgende Relation erfüllen:

$$B(E_x) = \frac{V_{z1} - V_{z2}}{V_{z1} \cdot V_{z2}} \cdot E_x \, ,$$

wobei

$V_{z1}$ die Geschwindigkeit der Primärelektronen und
$V_{z2}$ die Geschwindigkeit der Sekundärelektronen

angibt.

Bei dieser Wahl des Verhältnisses zwischen den elektrischen und magnetischen Feldstärken ist es somit möglich, daß die Primärelektronen und die Sekundärelektronen von dem Deflektor 69 um entgegengesetzt gleiche Winkel abgelenkt werden und sich deren Trajektorien somit decken.

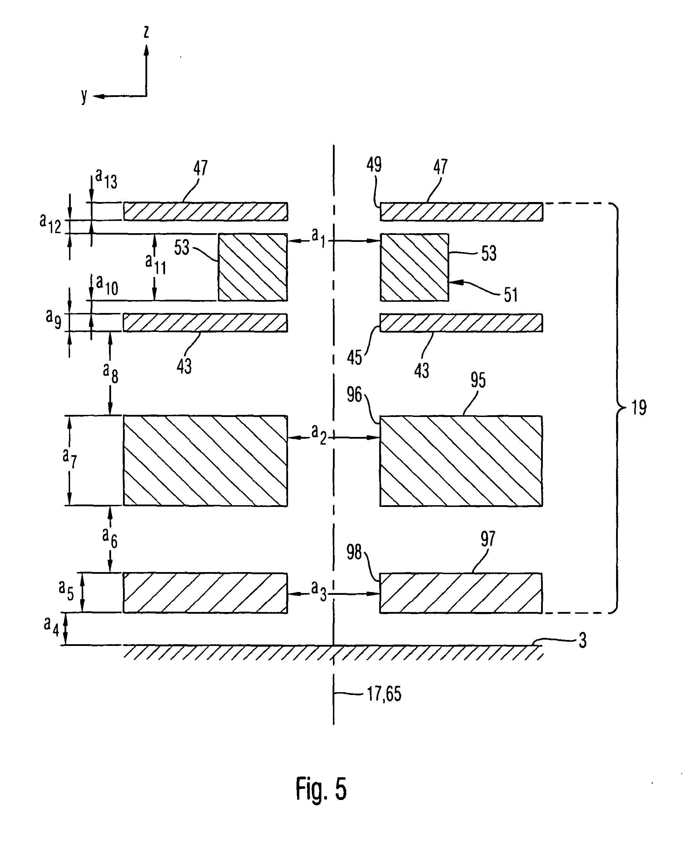

Das Objektiv 19 weist einen Aufbau auf, wie er in Figur 5 im Schnitt in der y-z-Ebene dargestellt ist. Es umfaßt zwei Schlitzblenden 43 und 47 sowie eine dazwischen angeordnete Kammblende 51 mit zwei Reihen von Fingerelektroden 53. Die räumliche Anordnung der Elektroden 43, 47 und 53 entspricht der, wie sie in Figur 2 perspektivisch dargestellt ist.

Die Schlitzblende 47 weist eine Schlitzöffnung 49 mit einer lichten Weite in y-Richtung $a_1$ von 5 mm auf. Ebenso weist die Schlitzblende 43 eine Öffnung 45 mit einer ebensolchen lichten Weite $a_1$ von 5 mm auf. Ebenfalls einander gegenüberliegende Fingerelektroden 53 haben einen Abstand von $a_1$ = 5 mm voneinander. Gesehen in z-Richtung weist die Blende 43 eine Dicke $a_9$ = 1 mm auf, ein Abstand $a_{10}$ zwischen der Blende 43 und dem Rand der Fingerelektroden 53 beträgt 1 mm, eine Ausdehnung $a_{11}$ der Fingerelektroden 53 in z-Richtung beträgt 6 mm, ein Abstand $a_{12}$ zwischen den Fingerelektroden 53 und der Blende 47 beträgt 1 mm, und eine Dicke $a_{13}$ der Blende 47 beträgt ebenfalls 1 mm.

Zwischen der Blende 43 und der Objektebene 3 ist eine weitere Blende 95 mit einer Schlitzöffnung 96 angeordnet, welche eine lichte Weite $a_2$ in y-Richtung von 5,5 mm aufweist. Die Blende 95 ist mit einem Abstand $a_8$ von 5,475 mm von der Blende 43 angeordnet und weist selbst eine Dicke $a_7$ von 6,75 mm auf. Zwischen der Blende 95 und der Objektebene 3 ist ferner eine weitere Blende 97 mit einer Schlitzöffnung 98 angeordnet, welche eine lichte Weite $a_3$ von 4,5 mm aufweist. Die Blende 97 ist mit einem Abstand $a_6$ von 6,525 mm von der Blende 95 und mit einem Abstand $a_4$ von 1,75 mm von der Objektebene 3 angeordnet und weist selbst eine Dicke $a_5$ von 2,5 mm auf.

Bei auf Erdpotential liegendem Objekt 3 ist an die Blende 97 eine Spannung von 4,1 kV angelegt, an die Blende 95 eine Spannung von 47,2 kV, an die Blende 43 eine Spannung von 14,8 kV und an die Blende 47 eine Spannung von 14,8 kV. Die Fingerelektroden 53 werden angesteuert, um ein Quadrupolfeld bezüglich der ausgelenkten Strahlachse 65 bereitzustellen.

Die Elektroden 47, 53, 43, 95 und 97 des Objektivs 19 wirken gemeinsam auf die das Objektiv 19 durchsetzenden Primär- und Sekundärelektronenstrahlen 81, 14. Sofern funktionelle Wirkungen dieser Elektroden auf den Sekundärelektronenstrahl überhaupt trennbar sind, so können diesen zum besseren Verständnis der Funktion des Objketivs 19 folgende Funktionen zugeordnet werden: Die Elektrode 97 wirkt als Extraktionselektrode, um zwischen der Elektrode 97 und dem in der Objektebene 3 angeordneten Objekt ein die Sekundärelektronen beschleunigendes elektrisches Feld bereitzustellen, welches umgekehrt die Primärelektronen vor dem Auftreffen auf dem Objekt abbremst. Die Elektrode 95 hat eine fokussierende Funktion. Die Fingerelektroden 53 stellen ein in x-Richtung fokussierendes Quadrupolfeld bereit, und die Elektroden 43 und 47 schirmen das Quadrupolfeld in z-Richtung ab.

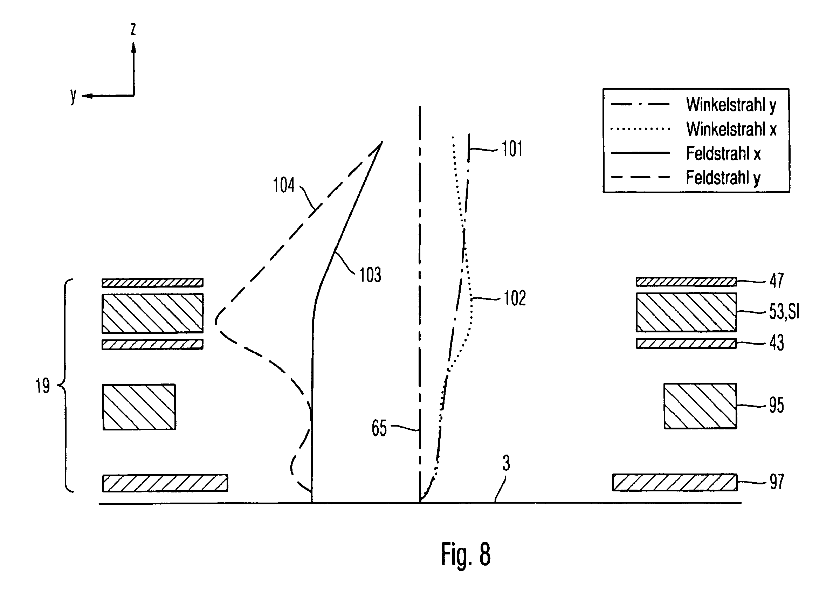

In Figur 8 sind Trajektorien bzw. Strahlverläufe von Sekundärelektronen, die das Objektiv 19 durchlaufen, schematisch dargestellt.

Darin bedeuten: eine strichpunktierte Linie 101 repräsentiert die Auslenkung eines Sekundärelektrons in x-Richtung, welches auf der Achse 65 unter einem Winkel in x-Richtung startet; eine gepunktete Linie 102 repräsentiert die Auslenkung eines Elektrons in y-Richtung, welches auf der Achse 65 in der Objektebene 3 unter einem Winkel in y-Richtung startet; eine durchgezogene Linie 103 repräsentiert die Auslenkung eines Elektrons in x-Richtung, welches mit Abstand von der Achse 65 und parallel zu dieser an der Objektebene 3 startet; eine gestrichelte Linie 104 repräsentiert die Auslenkung eines Elektrons in y-Richtung, welches mit Abstand von der Achse 65 und parallel zu dieser in der Objektebene 3 startet.

Aus dem Verlauf der Strahlen 101 bis 104 in Figur 8 ist ersichtlich, daß das Objektiv 19 auf die Sekundärelektronen in der xz-Ebene und in der yz-Ebene verschiedene Wirkungen bereitstellt, was als eine insgesamt astigmatische Wirkung des Objektivs 19 betrachtet werden kann. Eine solche Wirkung ist für eine Elektronenmikroskopieoptik zunächst grundsätzlich nicht vorteilhaft, allerdings weist das Objektiv 19 die Eigenschaft auf, daß diese Wirkung durch Ändern der Erregung der Fingerelektrode 53 in x-Richtung im wesentlichen beliebig verlagerbar ist (nämlich $\pm$ 15 mm in der beschriebenen Ausführungsform).

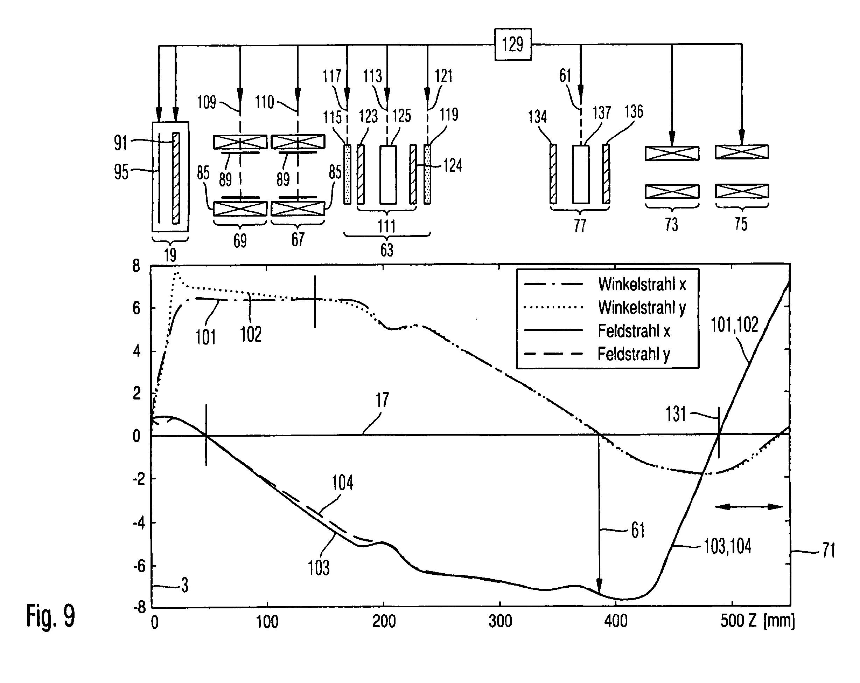

Die in dem Objektiv 19 zugelassene astigmatische Wirkung, das heißt von der Wirkung einer Rundlinse verschiedene Wirkung, wird im Strahlengang des Sekundärelektronenstrahls 14 nachfolgend durch den Strahlformer 63 kompensiert, wie dies aus Figur 9 ersichtlich ist. Diese zeigt im unteren Teil den Strahlengang der Mikroskopieoptik 11 zwischen der Objektebene 3 bei z = 0 mm und der zweiten Zwischenbildebene 71 bei z = 580 mm. In Figur 9 sind die in Figur 8 vergrößert dargestellten Verläufe der Strahlen 101, 102, 103 und 104 fortgesetzt. Oberhalb der Darstellungen der Strahlen 101 bis 104 befindet sich eine symbolische Darstellung der elektronenoptischen Komponenten der Optik 11. Dies sind: das vorangehend bereits im Detail erläuterte Objektiv 19. Die beiden Strahlablenker 69 und 67 mit Wicklungen 85 und Elektroden 89, wobei eine Mittelebene 109 des Strahlablenkers 69 bei z = 50 mm angeordnet ist und eine Mittelebene 110 des Strahlablenkers 67 bei z = 150 mm.

Der Srahlumformer 63 ist symmetrisch bezüglich einer Mittelebene 113 bei z = 210 mm aufgebaut und umfaßt eine Quadrupollinse 115 mit einer Mittelebene 117 bei z = 190 mm und eine weitere Quadrupollinse 119 bei bei einer Ebene 121 bei z = 230 mm. Zwischen den beiden Quadrupollinsen 115 und 119 ist eine elektrostatische Rundlinse 111 angeordnet, welche zwei Blendenelektroden 123 und 124 und eine zwischen diesen angeordnete Fokussierelektrode 125 umfaßt.

Die Aufgabe des Strahlformers 63 ist es, die nach Durchlaufen des Objektivs 19 auseinanderfallenden Strahlengänge 101/102 und 103/104 des Sekundärelektronenstrahls 14 wieder zusammenzuführen, so daß ein erstes Zwischenbild 61 ausreichender Qualität entsteht. Das Zwischenbild 61 entsteht bei der anhand der Figur 9 erläuterten Ausführungsform bei z = 385 mm.

Die Zusammenführung der Strahlen 101/102 bzw. 103/104 erfolgt durch die beiden mit Abstand in z-Richtung voneinander angeordneten Quadrupollinsen 115 und 119 sowie die Rundlinse 111, und zwar derart, daß die Strahlen 101 und 102 in dem Zwischenbild 61 beide die Achse 17 schneiden, weshalb ein im wesentlichen scharfe Abbildung der Objektebene 3 in der Ebene des Zwischenbilds 61 erfolgt. Ferner ist die Steigung der beiden Strahlen 101 und 102 zur Achse 17 in der Zwischenbildebene 61 im wesentlichen gleich, weshalb die Abbildung von der Objektebene 3 in die Zwischenbildebene 61 mit im wesentlichen gleichen Vergrößerungen in x-Richtung und in y-Richtung erfolgt.

Ferner weist die Abbildung der Objektebene 3 in die Zwischenbildebene 61 noch eine Eigenschaft auf, die aus Figur 9 nicht unmittelbar ersichtlich ist: zwei Strahlen, die in der Objektebene 3 auf der Achse 65 mit einem gleichen Winkel zu dieser starten und dabei unterschiedliche Energien aufweisen, schneiden die Achse 17 wieder an einem gemeinsamen Ort, nämlich an der Zwischenbildebene 61, so daß die Abbildung im wesentlichen frei von Ortsdispersion ist. Die Ortsdispersion ergibt sich aus einem Integral über das Produkt aus Dipolstärke mal Bahnhöhe für den Winkelstrahl x entlang den Achsen 65 bzw. 17. Eine Winkeldispersion ist bei der Abbildung allerdings zugelassen.

Bei einer Auslenkung der Achse 65 von der Hauptachse 17 von M = 0,0 mm müssen die Sekundärelektronen von dem unausgelenkten Objektfeld 13 bis zur Zwischenbildebene 61 eine Strecke von 580 mm durchlaufen. Diese Strecke vergrößert sich mit zunehmender Auslenkung M, da die Sekundärelektronen zwischen den beiden Ablenkern 69 und 67 schräg zur Hauptachse 17 verlaufen. Ferner werden die Strahlen die Ablenker 69 und 67 nicht exakt entlang der optischen Achse durchlaufen, so daß hierdurch ein Astigmatismus-Fehler erzeugt wird. Es ist somit ersichtlich, daß sich die Eigenschaften des fest bei z = 385 mm angeordneten Zwischenbilds 61 mit Auslenkung M des Objektfelds 13 in x-Richtung ebenfalls geringfügig ändern. Diese Änderungen können allerdings dynamisch korrigiert werden. Hierzu sind fünf Freiheitsgrade notwendig:

- für die Beibehaltung des Schnittpunkts der Winkelstrahlen 101 und 102 (x und y) mit der Achse 17 zwei Freiheitsgrade (1) und (2),

- für die Beibehaltung der Steigung der Winkelstrahlen 101 und 102 zur Achse 17 (x und y) zwei Freiheitsgrade (3) und (4), und

- für die Beibehaltung einer Ortsdispersion von im wesentlichen Null ein Freiheitsgrad (5).

Zum Nachstellen dieser Freiheitsgrade mit der Auslenkung M sind somit fünf frei einstellbare Parameter der Optik 11 notwendig und gegeben durch:

(i) die Änderung der an die in y-Richtung fokussierende Blende 95 des Objektivs 19 und gegebenenfalls an andere Blenden des Objektivs angelegte Spannung,

(ii) die Stärke des in x-Richtung fokussierenden Quadrupolfeldes der Kammblende 51 durch Ändern des an die Fingerelektroden 53 angelegten Spannungsmusters,

(iii) die Stärke der Fokussierwirkung der elektrostatischen Rundlinse 111 durch Ändern der an die Fokussierblende 125 angelegten Spannung,

(iv) Ändern der Stärke der Quadrupollinse 115, und

(v) Ändern der Stärke der Quadrupollinse 119.

Die Mikroskopieoptik 11 umfaßt hierzu eine Steuerung 129, welche die Erregung der Ablenker 69 und 67 einstellt, um eine gewünschte Auslenkung M einzustellen. Die Steuerung 129 steuert dann ferner noch mit der Fokussierblende 95, der Kammblende 51, der Quadrupollinse 115, der Rundlinse 111 und der weiteren Quadrupollinse 119 die vorangehend beschriebenen fünf Parameter (i) ... (v) derart an, daß mit den vorangehend beschriebenen fünf Freiheitsgraden (1) ... (5) der Optik das Zwischenbild 61 unabhängig von der Auslenkung M im wesentlichen stabil ist. Es gibt allerdings noch zwei Eigenschaften, die im Strahlengang hinter dem Zwischenbild 61 noch von der Auslenkung M abhängen, nämlich

(6) der Ort eines cross-overs 131, das heißt eines Schnittpunkts der Strahlen 103 und 104 mit der Achse 17, zwischen den beiden Zwischenbildern 61 und 71 kann sich entlang der Achse 17 verschieben. Damit ändert sich auch der Abstand des cross-overs 131 von der zweiten Bildebene 17. Dieser Abstand ist allerdings ein wichtiger Parameter für die nachfolgende Optik, nämlich die sog. Helmholz-Länge für den Energiefilter 73. Mit Änderung des Ortes des cross-overs 131 ändert sich somit auch die Funktion des Energiefilters 73, was unerwünscht ist. Dies entspricht auch einer Änderung der Steigungen der Feldbahnen 103 und 104.

Um den Freiheitsgrad (6) dynamisch nachzustellen, ist die in der Zwischenbildebene 61 angeordnete elektrostatische Fokussierlinse 77 von der Steuerung 129 angesteuert. Die Fokussierlinse 77 umfaßt zwei Schirmblenden 134 und 136, zwischen denen eine Fokussierelektrode 137 angeordnet ist, deren Potential von der Steuerung 129 geändert wird. Da die Fokussierlinse 77 in der Nähe der Zwischenbildebene angeordnet ist, wirkt sich eine Änderung von deren Stärke im wesentlichen auf die Feldbahnen 103, 104 aus, so daß damit der Freiheitsgrad (6) wirksam kompensierbar ist.

Um eine optische Vergrößerung in dem zweiten Zwischenbild zu erhöhen und die Helmholtz-Länge des Systems auf die des Energiefilters anzupassen, sind die beiden magnetischen Fokussierlinsen 73 und 75 vorgesehen, welche von der Steuerung 129 angesteuert werden, und zwar derart, daß der Ort des cross-overs 131 bei z = 500 mm stabil angeordnet ist und somit die Helmholz-Länge von 60 mm für den Energiefilter 73 konstant erfüllt ist.

Nachfolgend wird der Verlauf des Primärelektronenstrahls 81 durch die Optik 11 beschrieben.

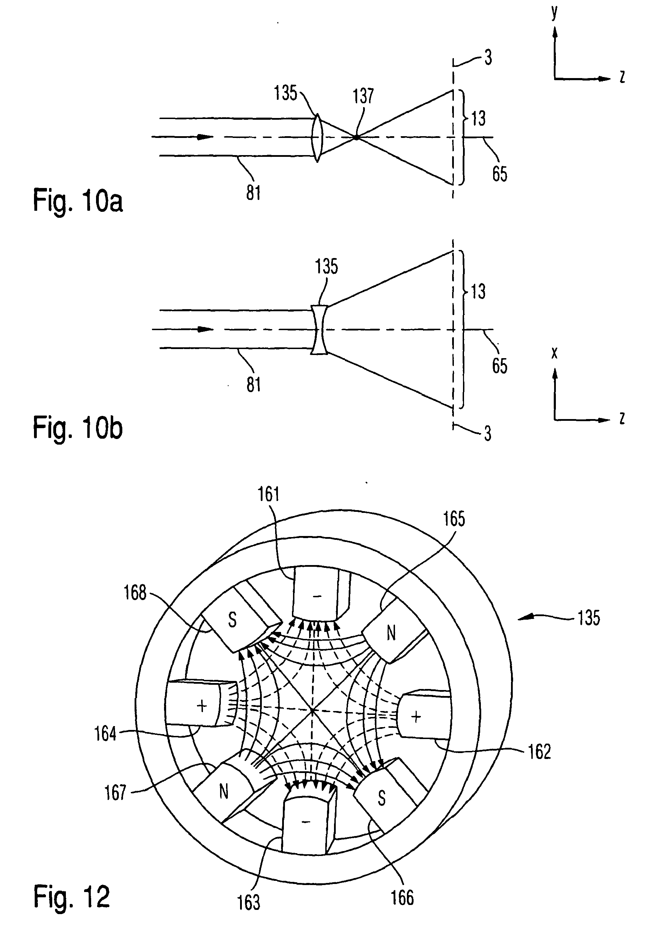

In der Ebene 110 des Ablenkers 67 ist auf den Primärelektronenstrahl 81 zusätzlich zu den übrigen optischen Elementen die Wirkung einer Quadrupollinse 135 bereitgestellt, wie dies in Figur 10 schematisch erläutert ist. Hierbei zeigt Figur 10a einen Schnitt in der yz-Ebene und Figur 10b einen Schnitt in der xz-Ebene entlang der Achse 65. Die Quadrupollinse 135 ist mit Abstand von der Objektebene 3 angeordnet und wirkt auf den Primärelektronenstrahl 81 in der yz-Ebene fokussierend, und zwar so stark, daß zwischen der Quadrupollinse 135 und der Objektebene 3 ein Strichfokus 137 entsteht. Nach Durchlaufen des Strichfokus' 137 trifft der Primärelektronenstrahl 81 auf die Objektebene 3 (Figur 4). Die Quadrupollinse 135 führt somit zu einer deutlichen Aufweitung des ausgeleuchteten Feldes der Objektebene 3 in y-Richtung.

In der xz-Ebene wirkt die Quadrupollinse 135 defokussierend, so daß ebenfalls in x-Richtung das ausgeleuchtete Objektfeld 113 durch die Quadrupollinse 135 deutlich aufgeweitet ist.

Nach dem anhand der Figur 10 erläuterten Prinzip ist es möglich, mit einem Primärelektronenstrahl 81 vergleichsweise kleinen Durchmessers ein relativ großes Objektfeld 113 auszuleuchten. Die Quadrupollinse 135 ist für den Primärelektronenstrahl 81 in der Ebene 110 des Ablenkers 67 bereitgestellt. Die Quadrupollinse 135 hat auf den Sekundärelektronenstrahl 14 im wesentlichen keine Wirkung. Insbesondere transmittiert die Quadrupollinse den Sekundärelektronenstrahl vollständig, das heißt Sekundärelektronen werden von der Quadrupollinse selbst nicht absorbiert. Ferner, und unabhängig davon, findet eine Beeinflussung der von der Quadrupollinse 135 transmittierten Elektronen durch das Quadrupolfeld auch nicht etwa derart statt, daß die Sekundärelektronen durch die Quadrupolfeldwirkung aus ihrer Bahn soweit abgelenkt werden, daß sie den nachfolgenden Strahlengang dann verlassen. Im wesentlichen alle die Quadrupollinse 135 passierenden Sekundärelektronen treffen auf den Detektor 7. Es können allerdings in dem System an anderen Stellen noch weitere Hilfsdetektoren vorgesehen sein. Gleichwohl treffen dann mehr als 50 %, insbesondere mehr als 80 % und weiter bevorzugt mehr als 90 % der von der Quadrupollinse durchgelassenen Elektronen den dann als Hauptdetektor wirkenden Detektor 7.

Hierzu weist die Quadrupollinse 135 einen Aufbau auf, der anhand der Figur 12 näher erläutert ist. Dort umfaßt die Quadrupollinse 135 vier in Umfangsrichtung um die Strahlachse verteilt angeordnete elektrische Feldquellelemente, d.h. Elektroden 161, 162, 163 und 164, wobei die beiden sich bezüglich der Strahlachse gegenüberliegenden Elektroden 161 und 163 auf einem negativem Potential sind und die quer hierzu orientierten uns sich ebenfalls gegenüberliegenden Elektroden 162 und 164 auf einen positivem Potential sind. Feldlinien des durch die Elektroden 161 bis 164 hervorgerufenen Quadrupolfeldes sind in Figur 12 mit gestrichelten Linien angedeutet. Vier magnetische Feldquellelemente bzw. Magnetpole 165, 166, 167 und 168 sind in Umfangsrichtung um die Strahlachse verteilt angeordnet und zwar derart, daß in Umfangsrichtung mittig zwischen zwei Elektroden 161 bis 164 jeweils ein Magnetpol 165 bis 168 angeordnet ist, welche in Umfangsrichtung abwechselnd einen magnetischen Nordpol und einen magnetischen Südpol bereitstellen. Zwischen den Magnetpolen 165 bis 168 entstehende Magnetfelder sind in Figur 12 durch durchgezogene Feldlinien angedeutet.

Die dargestellte Geometrie von Elektroden und Magnetpolen führt dazu, daß an jedem Ort in einem Bereich nahe der Strahlachse die magnetischen und elektrischen Feldlinien im wesentlichen senkrecht aufeinander stehen.

Die Stärken des magnetischen Quadrupolfelds und des elektrischen Quadrupolfelds sind so aufeinander abgestimmt, daß der Sekundärelektronenstrahl bei Durchlaufen der Quadrupollinse 135 im wesentlichen keine Quadrupolwirkung erfährt. Hierzu genügen die Felder der Quadrupolkomponente der Linse der folgenden Formel:

$$\vec{E} = -\vec{v} \times \vec{B}$$

wobei $\vec{E}$ das elektrische Feld, ä das magnetische Feld und $\vec{v}$ die Geschwindigkeit der Elektronen ist, auf die die Quadrupolkomponente des Feldes keine Wirkung haben soll.

Die Quadrupollinse 135 kann gleichzeitig als Strahlablenker wirken, indem die Elektroden 161 bis 164 und die Magnetpole 165 bis 168 derart angesteuert werden, daß den Quadrupolfeldern die Dipolfelder überlagert sind, um die Strahlablenkung herbeizuführen. Die hierzu erforderliche Ansteuerung und Bemessung der Dipolfelder wurde vorangehend bereits im Zusammenhang mit dem Ablenker gemäß Figuren 6 und 7 erläutert.

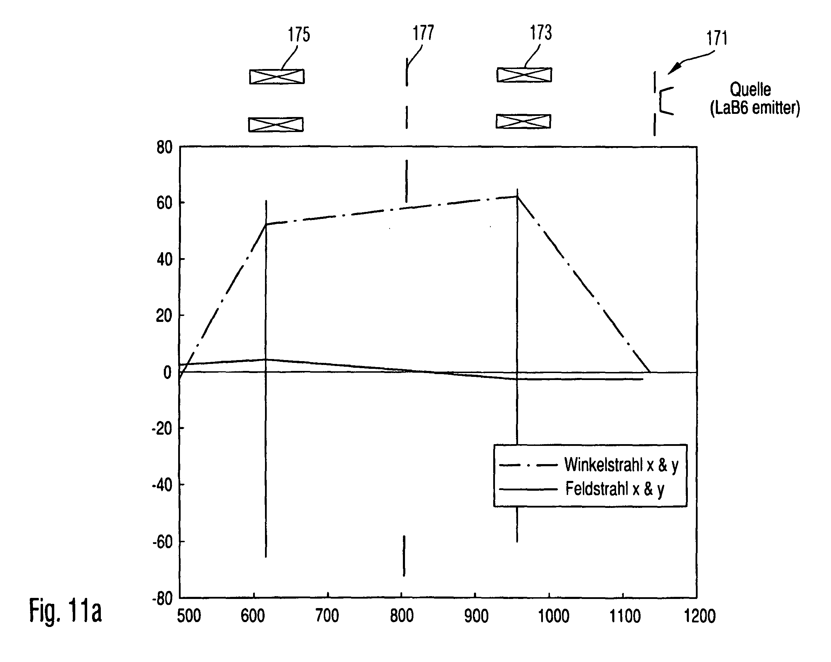

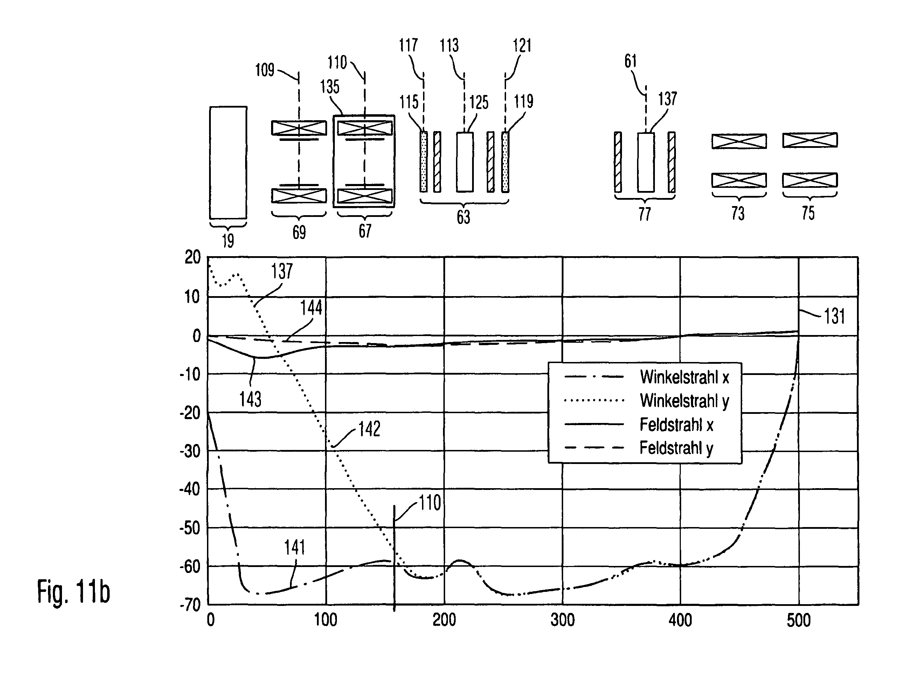

In den Figuren 11a und 11b ist der Strahlgang des Primärelektronenstrahls 81 durch die Optik 11 schematisch erläutert. Hierbei stellt Figur 11b den Strahlengang von der Objektebene 3 bis nahe der Strahlweiche 75 dar, während Figur 11a den Strahlengang im Anschluß hieran, also von nahe der Strahlweiche 75 bis zu einer Elektronenquelle 171 darstellt. In den Figuren 11a und 11b ist in den unteren Diagrammen jeweils der Strahlengang erläutert und den oberen Diagrammen sind die jeweils zugehörigen elektronenoptischen Komponenten symbolisch dargestellt. In den unteren Diagrammen repräsentiert eine strichpunktierte Linie 141 einen Strahl, der in einer Elektronenquelle 171 auf der Achse 17 unter einem Winkel in x-Richtung startet, eine punktierte Linie 142 repräsentiert einen Strahl, der in der Elektronenquelle 171 auf der Achse 17 unter einem Winkel in y-Richtung startet, eine durchgezogene Linie 143 repräsentiert einen Strahl, der in der Elektronenquelle 171 in x-Richtung neben der Achse 17 parallel zu dieser startet, und eine gestrichelte Linie 144 repräsentiert einen Strahl, der in der Elektronenquelle 171 in y-Richtung neben der Achse 17 und parallel zu dieser startet.

Unter Bezugnahme auf Figur 11a ist die Quelle 171 mit einem Abstand z = 1150 mm von der Objektebene 3 angeordnet. Die Quelle ist ein herkömmlich LaB6 Emitter. Der aus der Quelle 171 divergent austretende Strahl wird durch eine erste Kollimationslinse 173 bei z = 950 mm und eine zweite Kollimationslinse 175 bei z = 625 mm kollimiert, wobei bei z = 810 mm ein cross-over mit einer Feldblende 177 angeordnet ist. Hierdurch ist eine Köhlers'sche Beleuchtungsanordnung realisiert, da die Feldblende 177 weiterhin auf die Objektebene 3 abgebildet wird und mit der Aperturblende 177 das in der Objektebene 3 ausgeleuchtete Feld bestimmt ist.

Aus dem weiteren Verlauf der Strahlen 141, 142, 143, 144 in Figur 11b ist ersichtlich, daß die Quadrupollinsen 119 und 115 auf den Primärelektronenstrahl eine vergleichsweise geringe Wirkung haben und sich hierdurch die Strahlen 141 und 142 bzw. 143 und 144 vergleichsweise gering aufspalten. Die Quadrupollinse 135 führt in der Ebene 110 jedoch zu einer deutlichen Beeinflussung des Primärelektronenstrahls 81. Der Strahl 141 zeigt deutlich die Defokussierung in x-Richtung; und der Strahl 142 zeigt deutlich die Fokussierung in y-Richtung und die Bildung des Strichfokus' 137 bei z = 50 mm.

Figur 13a stellt noch eine Streublende 181 dar, welche bei z = 50 mm im Strahlengang der Primär- und Sekundärelektronen angeordnet ist, die in Figur 4 der Übersichtlichkeit halber allerdings nicht dargestellt ist. Die Streublende 181 weißt einen in x-Richtung sich erstreckenden Schlitz 183 auf, der von dem Primärelektronenstrahl 81 und dem Sekundärelektronenstrahl 14 durchsetzt ist. Die Ausdehnung des Schlitzes 183 in x-Richtung beträgt 30 mm und läßt damit die durch die Strahlablenker 67 und 69 eingestellte Auslenkung der beiden Strahlen 14 und 81 zu. In y-Richtung ist der Schlitz 183 200 $\mu$m breit und blendet damit aus dem Sekundärelektronenstrahl 14 Elektronen mit zu großer Divergenz aus.

In Figur 13b ist eine Variante der in Figur 13a dargestellten Streublende 181 dargestellt. Ein Schlitz 183' der in Figur 13b dargestellten Streublende 181' erstreckt sich nicht exakt in x-Richtung sondern schräg in der xy-Ebene. Diese Streublende 181' wird dann eingesetzt, wenn das untersuchte Objekt während des Abtastvorgangs in y-Richtung kontinuierlich relativ zu der Mikroskopieoptik bewegt wird. Es ist dann möglich, den Primärelektronenstrahl bzw. den Sekundärelektronenstrahl mit der Bewegung des Objekts in y-Richtung "mitzuführen". Am Ende eines Abtastvorgangs in x-Richtung springt der Strahl dann in x-Richtung zurück, um einen neuen Abtastvorgang zu beginnen.

Aufgrund der Ablenkung in y-Richtung durchsetzen der Primärelektronenstrahl und der Sekundärelektronenstrahl dann die Blenden des Objektivs 19 nicht mehr exakt auf dessen Mittelachse, sondern etwas versetzt dazu. Es ist möglich, das von den Fingerelektroden bereitgestellte Feld an diese Auslenkung anzupassen, indem die Elektroden einer Reihe insgesamt auf ein etwas höheres Potential gebracht werden als die der anderen Reihe. Hierdurch wird eine Mittelachse der zwischen den beiden Reihen von Fingerelektroden gebildeten Feldverteilung auch etwas gegenüber der geometrischen Mittelachse der Objektivlinse 19 verschoben. Sind die Auslenkungen der Strahlen in y-Richtung gering, so wird auch ohne Anpassung der Feldverteilung in y-Richtung noch eine ausreichend gute fokussierende Wirkung des Objektivs 19 erreicht.

Figur 13c stellt eine weitere Variante einer Streublende 181" dar, bei der das Rückspringen in x-Richtung am Ende eines Abtastvorgangs nicht notwendig ist. Es sind hierzu zwei gekreuzte Schlitze 183" in der Blende 181" vorgesehen. Am Ende eines Abtastvorgangs in x-Richtung springt der Strahl lediglich in y-Richtung in den jeweils anderen Schlitz 183", und ein neuer Abtastvorgang startet dann in die umgekehrte x-Richtung, wobei das Objekt weiterhin kontinuierlich in y-Richtung bewegt wird.

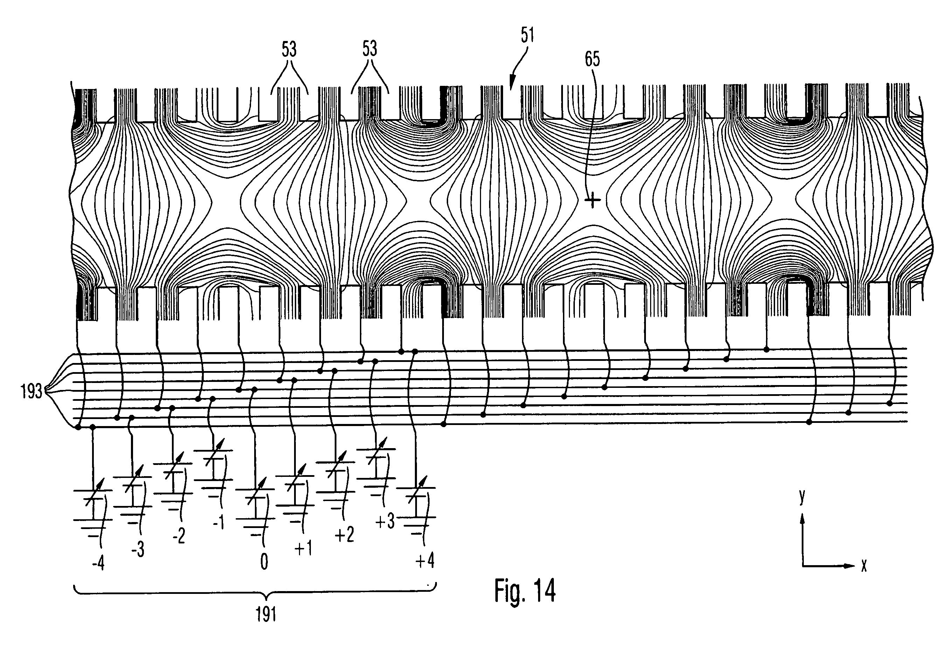

In Figur 14 ist eine Treiberanordnung 191 zur Ansteuerung der Fingerelektroden 53 der Kammlinse 51 schematisch dargestellt. Die Elektroden der Kammlinse 51 sind durch die Treiberanordnung 191 derart angesteuert, daß in der Umgebung der Strahlachse 65 ein quadrupolartiges Feld bereitgestellt ist. Wie vorangehend erläutert, ist die Strahlachse 65 in x-Richtung verlagerbar, und entsprechend muß das den Elektroden 53 zugeführte Spannungsmuster ebenfalls in x-Richtung verlagert werden.

Die Treiberanordnung 191 umfaßt lediglich neun Treiber bzw. Spannungsquellen, welche mit '-4', '-3', '-2', '-1', '0', '+1', '+2', '+3', '+4' bezeichnet sind. Die Spannungsquellen sind einzeln ansteuerbar. Eine jede Spannungsquelle ist an mehrere Elektroden 53 angeschlossen, eine jede Elektrode 53 ist jedoch nur mit einer einzigen Spannungsquelle verbunden. Hierzu erstrecken sich in Reihenrichtung, d.h. in x-Richtung neun Verbindungsleitungen 193, wobei eine jede Verbindungsleitung 193 mit einer einzigen Spannungsquelle verbunden ist. Die Elektroden 53 sind dann der Reihe nach und periodisch mit einer jeweils anderen Verbindungleitung 193 elektrisch verbunden.

In Figur 14 ist lediglich für eine Reihe Fingerelektroden 53 die zugehörige Treiberanordnung 191 dargestellt. Allerding ist auch für die andere Reihe Fingerelektroden 53 eine entsprechende Treiberanordnung samt Verbindungsleitungen vorgesehen.

Durch die im Vergleich zu der Zahl der Fingerelektroden 53 geringe Zahl von Spannungsquellen und durch die dargestellte Verdrahtung ist zwischen den beiden Reihen Fingerelektroden 53 ein periodisches Feldmuster erzeugt, obwohl lediglich in einem Bereich um die Strahlachse 65 ein entsprechendes Quadrupolfeld bereitgestellt werden muß. Allerdings ist bei der dargestellten Beschaltung eine im Vergleich zu der Zahl der Elektroden 53 besonders geringe Zahl an Treibern bzw. Spannungsquellen notwendig. Durch variieren der durch die einzelnen Spannungsquellen erzeugten Spannungen ist es möglich, daß Qudrupolfeld mit einer Verlagerung der Strahlachse 65 mitzuführen.

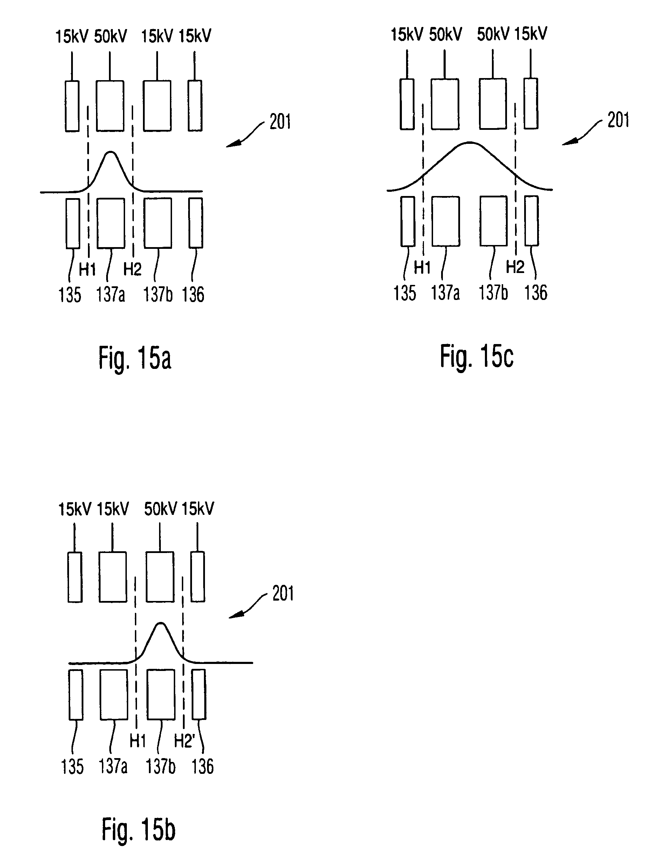

In Figur 15 ist eine Variante der vorangehend erläuterten Fokussierlinse 63 dargestellt. Die Fokusierlinse 201 gemäß Figur 15 umfaßt in z-Richtung hintereinander vier Blendenelektroden mit jeweils runder Blendenöffnung, welche auf durch die Steuerung 129 einstellbaren Potentiale gelegt werden können. Zwei in z-Richtung außen liegende Blendenelektroden wirken als Schirmblenden 135 und 136. Dazwischen sind zwei Fokusierelektroden 137a und 137b mit Abstand voneinander angeordnet. Durch unterschiedliches Ansteuern der Fokusierelektroden 137a und 137b ist es möglich, Hauptebenen H1 und H2 der Linse 201 in z-Richtung zu verlagern. Figur 15a zeigt eine erste Ansteuerung, in der die Fokusierelektrode 137a beispielhaft auf einem Potential auf 50 kV liegt und die übrigen Elektroden 135, 137b und 136 auf Strahlpotential von 15 kV liegen. Das Potential auf der z-Achse, d.h. das von dem die Linse 201 durchsetzenden Strahl wahrgenommene Potential, ist in Figur 15 jeweils als Kurve zwischen den Blendenöffnungen schematisch dargestellt. Entsprechend liegen die Hauptebenen H1 und H2 der bei dieser Ansteuerung bereitgestellten elektronenoptischen Linsenwirkung zwischen den Elektroden 135 und 137a bzw. 137a und 137b.

In Figur 15b ist die Ansteuerung derart, daß die Elektroden 135, 137a und 136 jeweils auf Strahlpotential von 15 kV liegen und die Fokusierelektrode 137b auf einem Potential von 50 kV liegt. Entsprechend liegen die Hauptebenen H1 und H2 zwischen den Elektroden 137a und 137b bzw. 137b und 136. Damit sind im Vergleich zur Figur 15a die beiden Hauptebenen H1 und H2 unter Beibehaltung ihres relativen Abstandes voneinander in z-Richtung verlagert. In einer weiteren in Figur 15c dargestellten Ansteuerung liegen lediglich die beiden Schirmelektroden 135 und 136 auf Strahlpotential von 15 kV, während beide Fokusierelektroden 137a und 137b auf 50 kV gelegt sind. Hierdurch ist die Linsenwirkung in z-Richtung auseinandergezogen, und die beiden Hauptebenen H1 und H2 liegen zwischen den Elektroden 135 und 137a bzw. 137b und 136.

Die Verlagerbarkeit der Hauptebenen H1, H2 der Linse 201 stellt einen Freiheitsgrad zur Beeinflussung des Sekundärelektronenstrahls in dem im Zusammenhang insbesondere mit Figur 1 und Figur 9 erläuterten System bereit. Wird die Fokusierlinse 201 an Stelle der Fokussierlinse 63 in Figur 9 eingesetzt, wird hier ein zusätzlicher Freiheitsgrad der Ansteuerung geschaffen, was es ermöglicht, die elektrostatische Linse 77 wegzulassen und an deren Stelle gegebenenfalls eine Feldblende einzufügen.

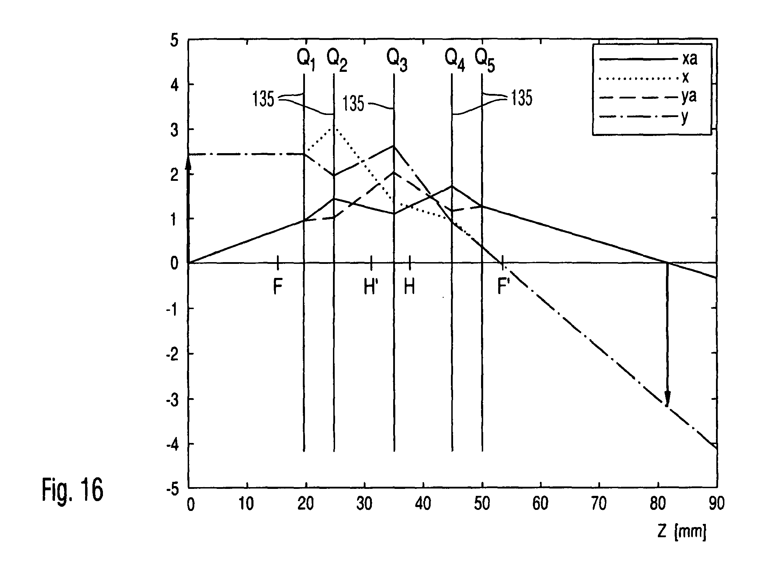

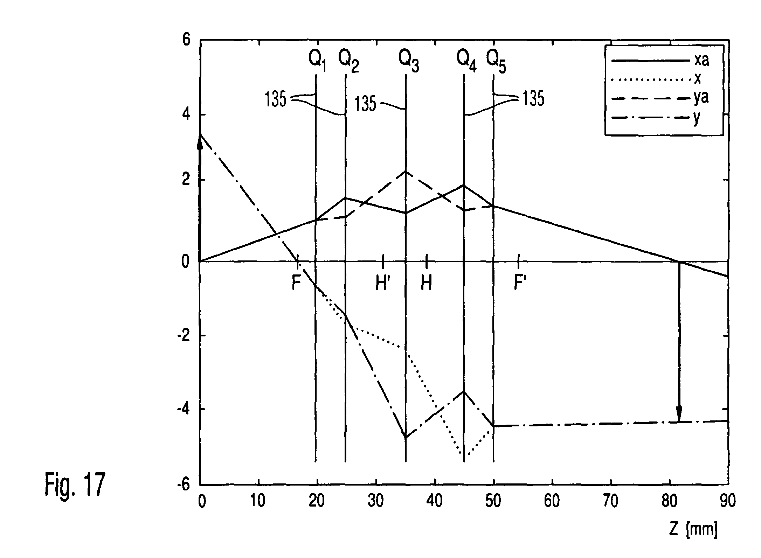

Vorangehend wurde im Zusammenhang mit Figur 10 eine Quadrupollinse beschrieben, deren Wirkung sich auf den Primärelektronenstrahl beschränkt und die auf den Sekundärelektronenstrahl im wesentlichen keine Wirkung hat. Der Einsatz von Quadrupollinsen aus gekreuzten elektrischen und magnetischen Feldern schafft für teilchenoptische Systeme mit entgegengesetzt zueinander verlaufenden Strahlen zusätzliche Freiheitsgrade. Ein weiteres Beispiel welches nicht Teil der Erfindung ist hierfür wird nachfolgend anhand der Figuren 16 und 17 erläutert.

Figur 16 zeigt eine Anordnung aus fünf Quadrupollinsen Q1 bis Q5, welche einen Aufbau haben können, wie die in Figur 12 gezeigte Quadrupollinse 135 mit gekreuzten elektrischen- und magnetischen Feldern. Brennweiten und Orte der fünf Quadrupollinsen entlang einer Strahlachse bzw. in z-Richtung sind in der nachfolgenden Tabelle angegeben

| | Q1 | Q2 | Q3 | Q4 | Q5 |
|---|---|---|---|---|---|
| f[mm] | -22,48 | 11 | -10,89 | 11 | -22,48 |
| z[mm] | 20 | 25 | 35 | 45 | 50 |

Figur 16 zeigt die Feld- und Winkelstrahlen, analog zu der Darstellung gemäß Figur 9, für einen ersten Strahl, der von einer bei z = 0 mm angeordneten Objektebene ausgeht. Es ist ersichtlich, daß ein Bild der Objektebene in einer bei z = 82 mm angeordneten Bildebene entsteht. Damit hat die Anordnung der fünf Quadrupollinsen auf den ersten Strahl die Wirkung einer dicken Rundlinse mit einer Brennweite f = 22 mm, bzw. einer Vergrößerung von 1,3.

In Figur 17 ist ein Strahlengang analog zu der Darstellung gemäß Figur 11 gezeigt, und zwar für einen Strahl, der die Anordnung der fünf Quadrupollinsen in der zur der im ersten Strahl entgegengesetzten zweiten Richtung durchläuft. Es sind in Figur 17 die Axial- und Feldstrahlen für den zweiten Strahl dargestellt, und zwar ausgehend von der Bildebene bei z = 82 mm. Es ist ersichtlich, daß die Anordnung der fünf Quadrupole auf den zweiten Strahl die Wirkung einer Rundlinse mit einer Brennweite von 22 mm bzw. eine Vergrößerung von 1/1,3 hat.

Aus den Figuren 16 und 17 ist ersichtlich, daß die Anordnung der fünf Quadrupollinsen auf beide Strahlen jeweils die gleiche Wirkung hat, und zwar insgesamt die Wirkung einer dicken Rundlinse mit Hauptebenen bei H = 38 mm, H' = 32 mm und Brennpunkten von F = 17 mm und F' = 53 mm. Damit ergibt sich eine Brennweite von rund 22 mm.

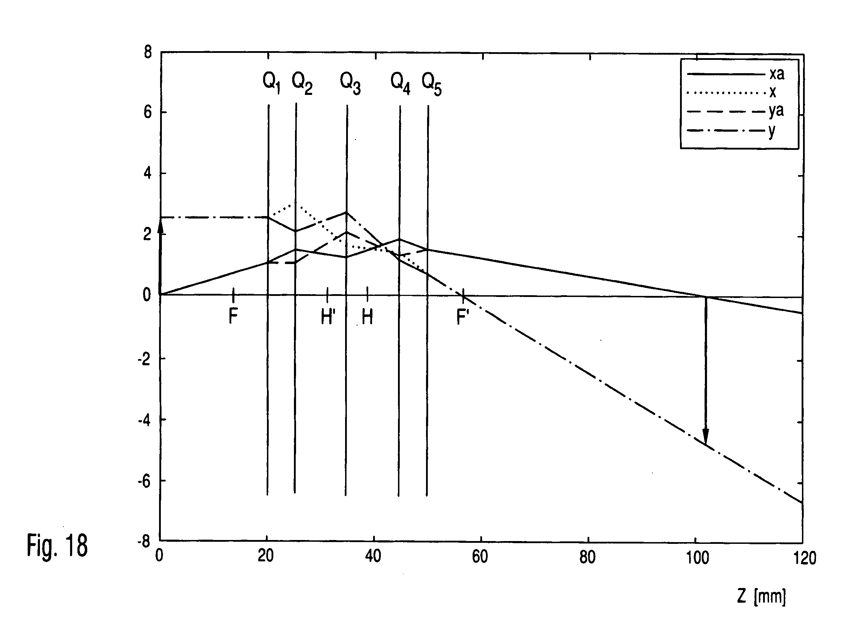

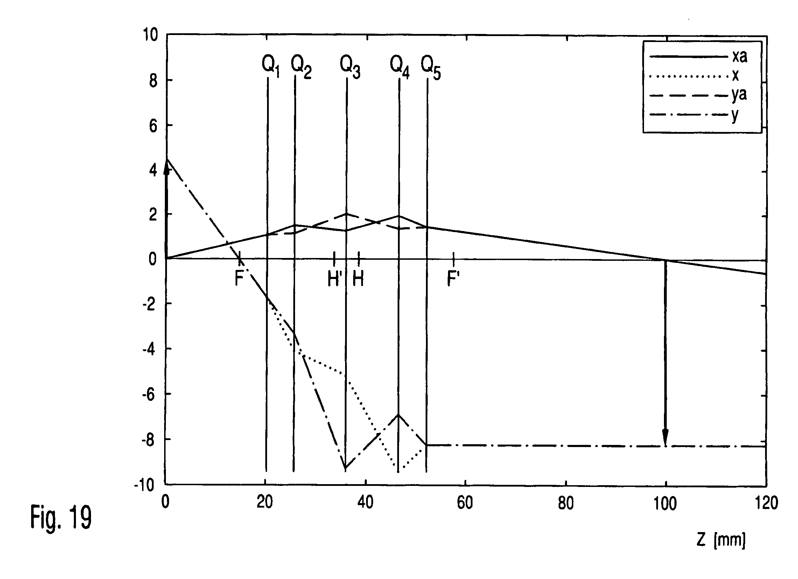

In den Figuren 18 und 19 ist eine Variante der in Figur 16 gezeigten Quadrupolanordnung dargestellt, wobei die Positionen der Quadrupole in z-Richtung die gleichen sind, deren Brennweiten durch eine geänderte Erregung der Linsen jedoch abgewandelt sind, wie aus der nachfolgenden Tabelle hervorgeht.

| | Q1 | Q2 | Q3 | Q4 | Q5 |
|---|---|---|---|---|---|
| f[mm] | -24,92 | 12 | -11,63 | 12 | -24,92 |
| Z[mm] | 20 | 25 | 35 | 45 | 50 |

Damit ergeben sich Hauptebenen H' = 32 mm, H = 38 mm, Vergrößerungen M = 1,8 und M' = 1/1,8 und eine Gesamtbrennweite von 24 mm.

Die in den Figuren 16 bis 18 erläuterte Anordnung von fünf Quadrupolen erlaubt die Breitstellung einer Rundlinsenfunktion, welche in erster Ordnung verzeichnungsfrei, in erster Ordnung stigmatisch und durchfokussierbar ist, und zwar selektiv für beide Strahlrichtungen.

Hierbei ist eine Vielzahl von Freiheitsgraden geschaffen, insbesondere können die Quadrupollinsen derart erregt werden, daß auf einen der beiden Strahlen im wesentlichen keine Wirkung erfolgt. Ferner können die Linsen so erregt werden, daß auf beide Strahlen eine Linsenwirkung bereitgestellt ist, die, insbesondere bei unterschiedlichen Energien der beiden Strahlen für beide Strahlen eine Rundlinsenwirkung gleicher Brennweite ist.

Ferner ist es möglich, die Zahl der Quadrupollinsen in der Anordnung zu verringern, wobei allerdings dann Einbußen hinsichtlich der Abbildungsqualität erfolgen müssen. Gleichwohl bietet die Anordnung dann auch noch die Vorteile, auf den einen oder anderen Strahl oder beide Strahlen selektiv bestimmte Linsenwirkungen bereitzustellen. Beispielsweise ist es möglich, mit lediglich zwei Quadrupolen eine Abbildung bereitzustellen, welche z.B. zwar in erster Ordnung stigmatisch ist, allerdings nicht mehr durchfokussierbar und verzeichnungsfrei ist.

In den vorangehend beschriebenen Beispielen, welche nicht Teil der Erfindung sind, sind die Stärken der elektrischen und magnetischen Quadrupolfelder so eingestellt, daß für die beiden in einander entgegengesetzte Richtungen verlaufenden Strahlen jeweils Quadrupollinsenwirkungen bereitgestellt sind.

Es ist jedoch auch möglich, die elektrischen und magnetischen Feldstärken derart einzustellen, daß einer der beiden Strahlen keine Quadrupollinsenwirkungen erfährt. Dann sollen bei einer jeden der Quadrupollinsen die elektrischen und magnetischen Felder derart aufeinander abgestimmt sein, daß sie der Formel

$$\vec{E} = -\vec{v} \times \vec{B}$$

genügen, wobei $\vec{v}$ die Geschwindigkeit der Elektronen des Strahls ist, der nicht beeinflußt werden soll.

Eine besondere Einstellung der elektrischen und magnetischen Felder ist auch dann gegeben, wenn beide Strahlen eine im wesentlichen gleiche Quadrupollinsenwirkung erfahren. Hierzu müssen die Quadrupolkomponenten der elektrischen und magnetischen Felder einer jeden Linse derart eingestellt werden, daß sie der Relation

$$B(E) = \frac{V_{z1} - V_{z2}}{V_{z1} \cdot V_{z2}} \cdot E$$

erfüllen, wobei

$V_{z1}$ die Geschwindigkeit der Primärelektronen und
$V_{z2}$ die Geschwindigkeit der Sekundärelektronen

angibt.

Abgesehen von den beiden vorangehend geschilderten speziellen Einstellungen, also einer im wesentlichen keine Beeinflussung einer der beiden Strahlen bzw. einer im wesentlichen gleichen Beeinflussung beider Strahlen, ist es jedoch auch möglich, für beide Strahlen eine Quadrupolwirkung vorzusehen, welche allerdings auf definierte und einstellbare Weise verschieden voneinander sind.

Ferner ist es möglich anstatt der vorangehend beschriebenen Quadrupollinsen Linsen mit höherer Symmetrie, beispielsweise Hexapolsymmetrie, einzusetzen und ebenfalls selektiv auf den einen oder den anderen oder beide Strahlen einzuwirken.

Der vorangehend im Zusammenhang mit Figur 4 beschriebene Energiefilter ist ein Energiefilter vom Ω-Typ. Es ist ebenfalls möglich, alternativ hierzu einen Energiefilter vom bekannten α-Typ einzusetzen.

Die vorangehend erläuterte Kammlinse umfaßt als Quellelemente Elektroden als Quellen von elektrischen Feldern. Alternativ hierzu ist es möglich, das Konzept auch auf magnetische Feldquellelemente zu übertragen. Die Feldquellelemente sind dann Magnetpole, welche beispielsweise durch eine Vielzahl von Spulen erregt werden, deren Treiber Stromquellen mit einstellbarer Stromstärke sind.

Die vorangehend beschriebenen Ausführungsformen bezogen sich jeweils auf ein Elektronenmikroskopiesystem. Es ist jedoch auch möglich, die Konzepte der Erfindung auf ein Lithograpiesystem zu übertragen, wie dies nachfolgend anhand von Figur 20 erläutert wird.

Figur 20 zeigt schematisch ein Lithographiesystem 181, dessen Aufbau erkennbar eine Abwandlung des in Figur 4 gezeigten Mikroskopiesystems ist. Das Lithographiesystem 181 umfaßt einen ersten Strahlumformer 19 mit einer Kammlinse 51 zur Bereitstellung eines in einer x-Richtung verlagerbaren quadrupolähnlichen Feldes, wobei zusätzliche in dem Strahlumformer vorgesehene Schlitzblenden in der Darstellung der Figur 19 nicht einbezogen sind. Ferner umfaßt das Lithograpiesystem 181 zwei mit Abstand in z-Richtung angeordnete Strahlablenker 67 und 69 und einen zweiten Strahlformer 63, der, ähnlich wie das vorangehend für das Mikroskopiesystem gemäß Figur 4 beschrieben wurde, eine verbleibende Quadrupolwirkung des ersten Strahlformers 19 kompensierende Wirkung auf einen Primärelektronenstrahl 81 hat. Der Primärelektronenstrahl 81 projiziert ein durch eine Linsenanordnung 183 bereit gestelltes Muster auf eine in einer Objektebene der Elektronenoptik angeordnete strahlungsempfindliche Schicht 185 ("Resist") eines zu fertigenden Halbleiterwafers 187.

Die Linsenanordnung 183 umfaßt eine Vielzahl von separaten in einem Feld angeordneten einzelnen Linsen 189, welche unabhängig voneinander ansteuerbar sind und einen von einer Elektronenquelle 191 erzeugten und durch eine Kollimationslinse 193 kollimierten Primärelektronenstrahl in ihren Linsenbereichen selektiv ein- und ausschalten können. Eine solche Linsenanordnung ist beispielsweise aus US 6,323,499 B1 bekannt, weshalb die Linsenanordnung 183 hier der Kürze halber nicht vollständig beschrieben wird.

Somit ist es mit dem Lithographiesystem 181 möglich auf die strahlungsempfindliche Schicht 185 mit dem Primärelektronenstrahl 81 Belichtungsmuster zu schreiben, wobei das Muster durch An- und Ausschalten der einzelnen Linsen 189 und durch Verlagern der Primärelektronenstrahlen 81 über die Strahlablenker 67 und 69 auf die Schicht 185 frei konfigurierbar geschrieben wird. Aufgrund der schaltbaren Linsenanordnung 183 ist das Lithographiesystem ein sogenanntes "maskenloses" Lithographiesystem. Es ist jedoch auch möglich, anstatt der schaltbaren Linsenanordnung 183 eine vorgefertigte Maske zur Definition der auf den Wafer übertragenen Muster einzusetzen.

Figur 20 zeigt noch eine optionale Besonderheit des Lithographiesystems 181. Die Optik 11 ist nämlich so ausgelegt, daß auch durch den Schreibstrahl 81 in der strahlungsempfindlichen Schicht 185 ausgelöste Sekundärelektronen durch die Optik 11 zurückgeführt werden. Diese werden dann in einer Strahlweiche 75 von dem Strahlengang des Primärelektronenstrahls 81 separiert und durch eine weiter in Figur 20 schematisch dargestellte Linsenanordnung 197 auf einen Detektor 7 abgebildet. Der Detektor 7 kann ortsauflösend sein und erlaubt jedenfalls die Erfassung eines Sekundärelektronenintensitätssignals, gegebenenfalls ortsauflösend und damit eine Überwachung des Schreibvorgangs. Insbesondere kann hierdurch festgestellt werden, ob die einzelnen Linsen 189 der Linsenanordnung 183 zufriedenstellend funktionieren.

Zusammenfassend wird ein Elektronenmikroskopiesystem vorgeschlagen, dessen Objektivlinse ein in einer x-Richtung verlagerbares Feld auf eine feste Strahlachse abbildet. Die Objektivlinse hat eine astigmatische Wirkung, die mit einem Strahlformer auf der festen Achse kompensiert wird.

Ferner werden nicht zur Erfindung gehörende Linsenkonfigurationen vorgeschlagen, welche selektiv auf den Primärelektronenstrahl oder den Sekundärelektronenstrahl wirken können.

**Patentansprüche**

1. Strahlführungssystem zum Ablenken eines Strahls (14) geladener Teilchen, umfassend:

   einen ersten Strahlformer (19), der dazu ausgebildet ist, im Betrieb von dem Strahl (14) entlang einer ersten Strahlachse (65) durchsetzt zu werden,
   einen zweiten Strahlformer (63), der dazu ausgebildet ist, im Betrieb von dem Strahl (14) entlang einer zweiten Strahlachse (17) durchsetzt zu werden, und
   wenigstens einen zwischen dem ersten Strahlformer (19) und dem zweiten Strahlformer (63) vorgesehenen Strahlablenker (69, 67), um die erste Strahlachse (65) innerhalb des ersten Strahlformers (19) in eine erste Richtung zu verlagern,
   wobei der erste Strahlformer (19) dazu ausgebildet ist, im Betrieb ein auf den Strahl (14) einwirkendes Strahlformungsfeld bereitzustellen, welches eine Feldkomponente mit Quadrupolsymmetrie bezüglich einer innerhalb des ersten Strahlformers (19) in der ersten Richtung verlagerbaren Symmetrieachse (65) umfaßt, wobei eine Fokussierwirkung des ersten Strahlformers (19) auf den Strahl (14) in einer zweiten Richtung (x) verschieden ist von seiner Fokussierwirkung auf den Strahl (14) in einer orthogonal zu der zweiten Richtung (x) orientierten dritten Richtung (y),
   wobei der zweite Strahlformer (63) dazu ausgebildet ist, im Betrieb ein auf den Strahl (14) einwirkendes Strahlformungsfeld bereitzustellen, welches eine Feldkomponente mit Quadrupolsymmetrie umfaßt, wobei eine Fokussierwirkung des zweiten Strahlformers (63) auf den Strahl (14) in der zweiten Richtung (x) verschieden ist von seiner Fokussierwirkung auf den Strahl (14) in der dritten Richtung (y),

   **dadurch gekennzeichnet, dass**
   der zweite Strahlformer (63) angeordnet ist, im Betrieb von dem Strahl (14) mit fester Position seines Strahlquerschnitts entlang der zweiten Strahlachse (17) durchsetzt zu werden.

2. Strahlführungssystem nach Anspruch 1, wobei die zweite Richtung (x) im wesentlichen parallel zu der ersten Richtung orientiert ist.

3. Strahlführungssystem nach Anspruch 1 oder 2, wobei der erste Strahlformer (19) eine in der ersten Richtung orientierte Schlitzblende (95) mit einer im wesentlichen in der ersten Richtung sich erstreckenden Längsöffnung zur Fokussierung des Strahls (14) in einer quer zu der ersten Richtung orientierten Richtung umfaßt.

4. Strahlführungssystem nach einem der Ansprüche 1 bis 3, wobei der zweite Strahlformer (63) zwei mit Abstand entlang der zweiten Strahlachse (17) angeordnete Quadrupollinsen (115, 119) aufweist.

5. Strahlführungssystem nach Anspruch 4, wobei die beiden Quadrupollinsen (115, 119) ausgebildet sind, im Betrieb in quer zueinander orientierten Ebenen fokussierend auf den Strahl (14) wirken.

6. Strahlführungssystem nach Anspruch 5, wobei der zweite Strahlformer (63) zwischen den beiden Quadrupollinsen (115, 119) eine Rundlinse (125) umfaßt.

7. Strahlführungssystem nach Anspruch 6, wobei die Rundlinse (125) zwischen den beiden Quadrupollinsen (115, 119) eine Rundlinse mit in Strahlrichtung verlagerbarer Hauptebene ist.

8. Strahlführungssystem nach einem der Ansprüche 1 bis 7, wobei zwischen dem ersten und dem zweiten Strahlformer eine sich in der ersten Richtung erstreckende Streublende vorgesehen ist.

9. Elektronenlithographiesystem zur Übertragung eines Musters auf eine strahlungsempfindliche Schicht mittels eins Schreibstrahls, wobei das Elektronenlithographiesystem das Strahlführungssystem nach einem der Ansprüche 1 bis 8 umfaßt.

10. Elektronenmikroskopiesystem zur Abbildung einer Objektebene (3) in eine Zwischenbildebene (61) mittels eines Strahls (14) von Sekundärelektronen, wobei zur Führung der Sekundärelektronen ein zwischen der Objektebene (3) und der Zwischenbildebene (61) angeordnetes Strahlführungssystem nach einem der Ansprüche 1 bis 8 vorgesehen ist.

11. Elektronenmikroskopiesystem nach Anspruch 10, ferner umfassend einen im Strahlengang hinter der Zwischenbildebene (61) angeordneten Energiefilter.

12. Elektronenmikroskopiesystem nach Anspruch 11, wobei zwischen dem zweiten Strahlformer und dem Energiefilter wenigstens eine Rundlinse (73, 75) vorgesehen ist.

13. Elektronenmikroskopiesystem nach Anspruch 10 oder 11, wobei nahe der Zwischenbildebene (61) eine elektrostatische Rundlinse (77) vorgesehen ist.

14. Elektronenmikroskopiesystem nach Anspruch 11 oder 12, wobei nahe der Zwischenbildebene (61) eine Feldblende vorgesehen ist.

15. Elektronenmikroskopiesystem nach einem der Ansprüche 11 bis 14, wobei der Energiefilter (73) ferner zur Einkopplung eines zu der Objektebene (3) hin gerichteten Primärelektronenstrahls (81) vorgesehen ist.

16. Elektronenmikroskopiesystem nach einem der Ansprüche 11 bis 15, wobei im Strahlengang des Sekundärelektronenstrahls (14) hinter dem Energiefilter ein ortsauflösender Elektronendetektor (7) vorgesehen ist.

17. Verfahren zum Abbilden eines in einer Objektebene (3) in einer ersten Richtung verlagerbaren Objektfeldes (13) in ein Bildfeld mittels eines Strahls (14) geladener Teilchen, umfassend:

   Bereitstellen eines ersten Quadrupolfeldes in einem Bereich nahe der Objektebene (3), wobei das erste Quadrupolfeld den von der Objektebene ausgehenden Strahl bezüglich einer ersten Strahlachse (65) in einer zweiten Richtung (x) fokussiert und in einer orthogonal zu der zweiten Richtung orientierten dritten Richtung (y) defokussiert,
   Ablenken des Strahls nach Durchlaufen des Quadrupolfeldes derart, daß er nach dem Ablenken entlang einer zweiten Strahlachse (17) verläuft, und
   Bereitstellen eines zweiten Quadrupolfeldes bezüglich der zweiten Strahlachse (17), und
   Verlagern der ersten Strahlachse (65) in der ersten Richtung und relativ zu der zweiten Strahlachse (17),

   **dadurch gekennzeichnet, dass**
   das Bildfeld im wesentlichen in einer ersten Zwischenbildebene (61) feststeht.

18. Verfahren nach Anspruch 17, ferner umfassend Ändern einer Stärke des ersten Quadrupolfeldes in Abhängigkeit von der Verlagerung der ersten Strahlachse.

19. Verfahren nach Anspruch 17 oder 18, ferner umfassend Ändern einer Stärke des zweiten Quadrupolfeldes in Abhängigkeit von der Verlagerung der ersten Strahlachse.

20. Verfahren nach einem der Ansprüche 17 bis 19, ferner umfassend Bereitstellen wenigstens eines Zylinderlinsenfeldes in einem Bereich nahe der Objektebene, wobei das Zylinderlinsenfeld den von der Objektebene ausgehenden Strahl in der zweiten Richtung (y) fokussiert.

21. Verfahren nach Anspruch 20, ferner umfassend Ändern einer Stärke des wenigstens einen Zylinderlinsenfeldes in Abhängigkeit von der Verlagerung der ersten Strahlachse.

22. Verfahren nach einem der Ansprüche 17 bis 21, ferner umfassend Bereitstellen eines mit Abstand entlang der zweiten Strahlachse von dem zweiten Quadrupolfeld angeordneten dritten Quadrupolfeldes bezüglich der zweiten Strahlachse und Ändern einer Stärke des dritten Quadrupolfeldes in Abhängigkeit von der Verlagerung der ersten Strahlachse.

23. Verfahren nach einem der Ansprüche 17 bis 22, ferner umfassend Bereitstellen eines ersten Rundlinsenfeldes bezüglich der zweiten Strahlachse.

24. Verfahren nach Anspruch 23, ferner umfassend Ändern einer Stärke des ersten Rundlinsenfeldes in Abhängigkeit von der Verlagerung der ersten Strahlachse.

25. Verfahren nach einem der Ansprüche 17 bis 24, wobei das erste Zwischenbild in ein zweites Zwischenbild abgebildet wird und das Verfahren ferner umfaßt: Bereitstellen eines zweiten Rundlinsenfeldes bezüglich der zweiten Strahlachse und Ändern einer Stärke des zweiten Rundlinsenfeldes in Abhängigkeit von der Verlagerung der ersten Strahlachse.

26. Verfahren nach Anspruch 25, ferner umfassend Bereitstelle eines dritten oder/und vierten Rundlinsenfeldes zwischen dem ersten Zwischenbild und dem zweiten Zwischenbild und Ändern einer Stärke des dritten oder/und vierten Rundlinsenfeldes in Abhängigkeit von der Verlagerung der ersten Strahlachse.

**Claims**

1. A beam guiding system for deflecting a beam (14) of charged particles, the system comprising:

   a first beam shaper (19) configured to be traversed, in operation, by the beam (14) along a first beam axis (65);
   a second beam shaper (63) configured to be traversed, in operation, by the beam (14) along a second beam axis (17); and
   at least one beam deflector (69, 67) provided between the first beam shaper (19) and the second beam shaper (63), for displacing the first beam axis (65) within the first beam shaper (19) in a first direction,
   wherein the first beam shaper (19) is configured to provide, in operation, a beam shaping field acting on the beam (14) and comprising a field component having quadrupole symmetry with respect to an axis of symmetry (65) which is displaceable within the first beam shaper (19) in the first direction, wherein a focusing effect of the first beam shaper (19) on the beam (14) in a second direction (x) is different from its focusing effect on the beam (14) in a third direction (y) oriented orthogonally with respect to the second direction (x),
   wherein the second beam shaper (63) is configured to provide, in operation, a beam shaping field acting on the beam (14) and comprising a field component with quadrupole symmetry, wherein a focusing effect of the second beam shaper (63) on the beam (14) in the second direction (x) is different from its focusing effect on the beam (14) in the third direction (y),

   **characterized in that**
   the second beam shaper (63) is arranged to be traversed, in operation, by the beam (14) with a fixed position of its cross-section along the second beam axis (17).

2. The beam guiding system according to claim 1, wherein the second direction (x) is oriented substantially in parallel to the first direction.

3. The beam guiding system according to claim 1 or 2, wherein the first beam shaper (19) comprises a slit aperture (95) being oriented in the first direction, the slit aperture (95) having an aperture elongated substantially in the first direction, for focusing the beam (14) in a direction oriented transversely to the first direction.

4. The beam guiding system according to one of claims 1 to 3, wherein the second beam shaper (63) comprises two quadrupole lenses (115, 119) spaced apart from each other along the second beam axis (17).

5. The beam guiding system according to claim 4, wherein the two quadrupole lenses (115, 119) are configured to have, in operation, a focusing effect on the beam (14) in planes oriented transversely to each other.

6. The beam guiding system according to claim 5, wherein the second beam shaper (63) comprises a round lens (125) located in between the two quadrupole lenses (115, 119).

7. The beam guiding system according to claim 6, wherein the round lens (125) between the two quadrupole lenses (115, 119) is a round lens having a main plane that is displaceable in beam direction.

8. The beam guiding system according to one of claims 1 to 7, wherein a scattering stop extending in the first direction is provided between the first and the second beam shapers.

9.  An electron lithography system for transferring a pattern onto a radiation-sensitive substrate by means of a writing beam, wherein the electron lithography system comprises a beam guiding system according to one of claims 1 to 8.

10. An electron microscopy system for imaging an object plane (3) on an intermediate image plane (61) by means of a beam (14) of secondary electrons, wherein, for guiding the secondary electrons, a beam guiding system according to one of claims 1 to 8 is provided, the beam guiding system being disposed between the object plane (3) and the intermediate image plane (61).

11. The electron microscopy system according to claim 10, further comprising an energy filter disposed in the beam path downstream of the intermediate image plane (61).

12. The electron microscopy system according to claim 11, wherein at least one round lens (73, 75) is provided between the second beam shaper and the energy filter.

13. The electron microscopy system according to claim 10 or 11, wherein an electrostatic round lens (77) is provided near the intermediate image plane (61).

14. The electron microscopy system according to claim 11 or 12, wherein a field aperture is provided near the intermediate image plane (61).

15. The electron microscopy system according to one of claims 11 to 14, wherein the energy filter (73) is further provided for insertion of a primary electron beam (81) that is directed to the object plane (3).

16. The electron microscopy system according to one of claims 11 to 15, wherein a position-sensitive electron detector (7) is provided in the beam path of the secondary electron beam (14) downstream of the energy filter.

17. A method of imaging an object field (13) that is displaceable in an object plane (3) in a first direction into an image field by means of a beam (14) of charged particles, the method comprising:

    providing a first quadrupole field in a region near the object plane (3), wherein the first quadrupole field focuses the beam emanating from the object plane in a second direction (x) with respect to a first beam axis (65) and defocuses the beam in a third direction (y) oriented orthogonally to the second direction,
    deflecting the beam, after the same has traversed the quadrupole field, such that, after the deflection, it extends along a second beam axis (17), and
    providing a second quadrupole field with respect to the second beam axis (17), and
    displacing the first beam axis (65) in the first direction and relative to the second beam axis (17),

    **characterized in that**
    the image field is substantially fixed in a first intermediate image plane (61).

18. The method according to claim 17, further comprising changing a strength of the first quadrupole field in dependence of the displacement of the first beam axis.

19. The method according to claim 17 or 18, further comprising changing a strength of the second quadrupole field in dependence of the displacement of the first beam axis.

20. The method according to one of claims 17 to 19, further comprising providing at least one cylinder lens field in a region near the object plane, wherein the cylinder lens field focuses the beam emanating from the object plane in the second direction (y).

21. The method according to claim 20, further comprising changing a strength of the at least one cylinder lens field in dependence of the displacement of the first beam axis.

22. The method according to one of claims 17 to 21, further comprising providing a third quadrupole field with respect to the second beam axis spaced apart from the second quadrupole field along the second beam axis, and changing a strength of the third quadrupole field in dependence of the displacement of the first beam axis.

23. The method according to one of claims 17 to 22, further comprising providing a first round lens field with respect to the second beam axis.

24. The method according to claim 23, further comprising changing a strength of the first round lens field in dependence of the displacement of the first beam axis.

25. The method according to one of claims 17 to 24, wherein the first intermediate image is imaged into a second intermediate image and the method further comprises: providing a second round lens field with respect to the second beam axis, and changing a strength of the second round lens field in dependence of the displacement of the first beam axis.

26. The method according to claim 25, further comprising providing a third or/and fourth round lens field(s) between the first intermediate image and the second intermediate image, and changing a strength of the third or/and fourth round lens field(s) in dependence of the displacement of the first beam axis.

**Revendications**

1. Système de guidage de faisceau pour dévier un faisceau (14) de particules chargées, comprenant :

un premier dispositif de mise en forme de faisceau (19) qui est en outre conçu pour être traversé par le faisceau (14) le long d'un premier axe de faisceau (65) pendant le fonctionnement,
un second dispositif de mise en forme de faisceau (63) qui est en outre conçu pour être traversé par le faisceau (14) le long d'un second axe de faisceau (17) pendant le fonctionnement, et
au moins un déflecteur de faisceau (69, 67) prévu entre le premier dispositif de mise en forme de faisceau (19) et le second dispositif de mise en forme de faisceau (63) afin de déplacer le premier axe de faisceau (65) à l'intérieur du premier dispositif de mise en forme de faisceau (19) dans une première direction,
dans lequel le premier dispositif de mise en forme de faisceau (19) est en outre conçu pour mettre à disposition, pendant le fonctionnement, un champ de mise en forme de faisceau agissant sur le faisceau (14), lequel comprend une composante de champ avec une symétrie quadripolaire par rapport à un axe de symétrie (65) déplaçable dans la première direction à l'intérieur du premier dispositif de mise en forme de faisceau (19), une action de focalisation du premier dispositif de mise en forme de faisceau (19) sur le faisceau (14) dans une deuxième direction (x) étant différente de son action de focalisation sur le faisceau (14) dans une troisième direction (y) orientée de façon orthogonale par rapport à la deuxième direction (x),
dans lequel le second dispositif de mise en forme de faisceau (63) est en outre conçu pour mettre à disposition, pendant le fonctionnement, un champ de mise en forme de faisceau agissant sur le faisceau (14), lequel comprend une composante de champ avec une symétrie quadripolaire, une action de focalisation du second dispositif de mise en forme de faisceau (63) sur le faisceau (14) dans la deuxième direction (x) étant différente de son action de focalisation sur le faisceau (14) dans la troisième direction (y),

**caractérisé en ce que**
le second dispositif de mise en forme de faisceau (63) est agencé pour être traversé par le faisceau (14) avec la position fixe de sa section transversale de faisceau, le long du second axe de faisceau (17), pendant le fonctionnement.

2. Système de guidage de faisceau selon la revendication 1, dans lequel la deuxième direction (x) est essentiellement orientée parallèlement à la première direction.

3. Système de guidage de faisceau selon la revendication 1 ou 2, dans lequel le premier dispositif de mise en forme de faisceau (19) comprend un diaphragme à fente (95) orienté dans la première direction, avec une ouverture longitudinale s'étendant essentiellement dans la première direction pour la focalisation du faisceau (14) dans une direction orientée de manière transversale par rapport à la première direction.

4. Système de guidage de faisceau selon l'une quelconque des revendications 1 à 3, dans lequel le second dispositif de mise en forme de faisceau (63) est pourvu de deux lentilles quadripolaires (115, 119) agencées à une certaine distance le long du second axe de faisceau (17).

5. Système de guidage de faisceau selon la revendication 4, dans lequel les deux lentilles quadripolaires (115, 119) sont conçues de sorte que, pendant le fonctionnement, elles ont, sur le faisceau (14), un effet focalisant dans des plans orientés de manière transversale l'un par rapport à l'autre.

6. Système de guidage de faisceau selon la revendication 5, dans lequel le second dispositif de mise en forme de faisceau (63) comprend une lentille circulaire (125) entre les deux lentilles quadripolaires (115, 119).

7. Système de guidage de faisceau selon la revendication 6, dans lequel la lentille circulaire (125) entre les deux lentilles quadripolaires (115, 119) est une lentille circulaire avec un plan principal mobile dans la direction du faisceau.

8. Système de guidage de faisceau selon l'une quelconque des revendications 1 à 7, dans lequel un écran de dispersion s'étendant dans la première direction est prévu entre le premier et le second dispositifs de mise en forme de faisceau.

9. Système de lithographie électronique pour transposer, au moyen d'un faisceau d'écriture, un modèle sur une couche sensible au faisceau, le système de lithographie électronique comprenant le système de guidage de faisceau selon l'une quelconque des revendications 1 à 8.

10. Système de microscopie électronique pour imager un plan objet (3) dans un plan d'image intermédiaire (61) au moyen d'un faisceau (14) d'électrons secondaires, dans lequel est prévu un système de guidage de faisceau selon l'une quelconque des revendications 1 à 8, agencé entre le plan objet (3) et le plan d'image intermédiaire (61), pour le guidage des électrons secondaires.

11. Système de microscopie électronique selon la revendication 10, comprenant en outre un filtre à énergie agencé dans la trajectoire du faisceau derrière le plan d'image intermédiaire (61).

12. Système de microscopie électronique selon la revendication 11, dans lequel au moins une lentille circulaire (73, 75) est prévue entre le second dispositif de mise en forme de faisceau et le filtre à énergie.

13. Système de microscopie électronique selon la revendication 10 ou 11, dans lequel une lentille circulaire électrostatique (77) est prévue près du plan d'image intermédiaire (61).

14. Système de microscopie électronique selon la revendication 11 ou 12, dans lequel un diaphragme de champ est prévu près du plan d'image intermédiaire (61).

15. Système de microscopie électronique selon l'une quelconque des revendications 11 à 14, dans lequel le filtre à énergie (73) est en outre prévu pour coupler un faisceau d'électrons primaires (81) dirigé vers le plan objet (3).

16. Système de microscopie électronique selon l'une quelconque des revendications 11 à 15, dans lequel un détecteur électronique de localisation (7) est prévu dans la trajectoire du faisceau d'électrons secondaires (14), derrière le filtre à énergie.

17. Procédé d'imagerie d'un champ objet (13) mobile dans une première direction dans un plan objet (3), dans un champ d'image, au moyen d'un faisceau (14) de particules chargées, comprenant :

la mise à disposition d'un premier champ quadripolaire dans une zone proche du plan objet (3), le premier champ quadripolaire focalisant le faisceau sortant du plan objet dans une deuxième direction (x) par rapport à un premier axe de faisceau (65) et le défocalisant dans une troisième direction (y) orientée dans une direction orthogonale par rapport à la deuxième direction,
la déviation du faisceau après avoir traversé le champ quadripolaire, de sorte qu'il passe le long d'un second axe de faisceau (17) après la déviation, et
la mise à disposition d'un deuxième champ quadripolaire par rapport au second axe de faisceau (17), et
le déplacement du premier axe de faisceau (65) dans la première direction et par rapport au second axe de faisceau (17),

**caractérisé en ce que**
le champ d'image est fixé essentiellement dans un premier plan d'image intermédiaire (61).

18. Procédé selon la revendication 17, comprenant en outre une modification d'intensité du premier champ quadripolaire en fonction du déplacement du premier axe de faisceau.

**19.** Procédé selon la revendication 17 ou 18, comprenant en outre une modification d'intensité du deuxième champ quadripolaire en fonction du déplacement du premier axe de faisceau.

**20.** Procédé selon l'une quelconque des revendications 17 à 19, comprenant en outre la mise à disposition d'au moins un champ de lentille cylindrique dans une zone proche du plan objet, le champ de la lentille cylindrique focalisant le faisceau sortant du plan objet dans la deuxième direction (y).

**21.** Procédé selon la revendication 20, comprenant en outre une modification d'intensité du au moins un champ de lentille cylindrique en fonction du déplacement du premier axe de faisceau.

**22.** Procédé selon l'une quelconque des revendications 17 à 21, comprenant en outre la mise à disposition d'un troisième champ quadripolaire, par rapport au second axe de faisceau, agencé à une certaine distance le long du second axe de faisceau depuis le deuxième champ quadripolaire et une modification d'intensité du troisième champ quadripolaire en fonction du déplacement du premier axe de faisceau.

**23.** Procédé selon l'une quelconque des revendications 17 à 22, comprenant en outre la mise à disposition d'un premier champ de lentille circulaire par rapport au second axe de faisceau.

**24.** Procédé selon la revendication 23, comprenant en outre une modification d'intensité du premier champ de lentille circulaire en fonction du déplacement du premier axe de faisceau.

**25.** Procédé selon l'une quelconque des revendications 17 à 24, dans lequel la première image intermédiaire est imagée dans une seconde image intermédiaire, le procédé comprenant en outre la mise à disposition d'un deuxième champ de lentille circulaire par rapport au second axe de faisceau et une modification d'intensité du deuxième champ de lentille circulaire en fonction du déplacement du premier axe de faisceau.

**26.** Procédé selon la revendication 25, comprenant en outre la mise à disposition d'un troisième et/ou quatrième champ de lentille circulaire entre la première image intermédiaire et la seconde image intermédiaire et une modification d'intensité du troisième et/ou quatrième champ de lentille circulaire en fonction du déplacement du premier axe de faisceau.

Fig. 1

Fig. 2

Fig. 3a          Fig. 3b          Fig. 3c

Fig. 4

Fig. 4-1

EP 1 389 794 B1

EP 1 389 794 B1

Fig. 4-2

Fig. 5

Fig. 6

Fig. 7

Fig. 8

Legend:
- —·—·— Winkelstrahl y
- ·········· Winkelstrahl x
- ——— Feldstrahl x
- — — — Feldstrahl y

Fig. 9

Fig. 10a

Fig. 10b

Fig. 12

Fig. 11a

Fig. 11b

Fig. 13a

Fig. 13b

Fig. 13c

Fig. 20

Fig. 14

15kV 50kV  15kV 15kV

201

H1    H2
135  137a  137b  136

## Fig. 15a

15kV 15kV  50kV 15kV

201

H1    H2'
135  137a  137b  136

## Fig. 15b

15kV 50kV  50kV 15kV

201

H1    H2
135  137a  137b  136

## Fig. 15c

Fig. 16

EP 1 389 794 B1

Fig. 17

Fig. 18

Fig. 19

**IN DER BESCHREIBUNG AUFGEFÜHRTE DOKUMENTE**

**In der Beschreibung aufgeführte Patentdokumente**

- EP 1280184 A2
- US 4376249 A
- US 6326629 B, Krijn
- EP 1182684 A2, de Jager
- EP 0218920 A2
- US 6323499 B1

**In der Beschreibung aufgeführte Nicht-Patentliteratur**

- **VON GOTO et al.** MOL (Moving Objective Lens. *Optic,* 1977, vol. 48, 255ff